(19) Europäisches Patentamt

European Patent Office

Office européen des brevets

(11) **EP 1 734 068 A1**

(12) **EUROPEAN PATENT APPLICATION**
published in accordance with Art. 158(3) EPC

(43) Date of publication:
**20.12.2006 Bulletin 2006/51**

(51) Int Cl.:
*C08J 5/24* (2006.01)      *B32B 15/08* (2006.01)
*C08K 7/02* (2006.01)      *C08L 63/00* (2006.01)
*H05K 1/03* (2006.01)      *H05K 3/00* (2006.01)
*C08L 101/00* (2006.01)

(21) Application number: **05719312.0**

(22) Date of filing: **18.02.2005**

(86) International application number:
**PCT/JP2005/002643**

(87) International publication number:
**WO 2005/085334 (15.09.2005 Gazette 2005/37)**

(84) Designated Contracting States:
**DE GB**

(30) Priority: **09.03.2004 JP 2004066021**

(71) Applicant: **POLYMATECH CO., LTD.**
**Tokyo 103-8424 (JP)**

(72) Inventors:
• **TOBITA, Masayuki**
**POLYMATECH CO., LTD. R & D Centr.**
**Tokyo 1140014 (JP)**
• **KIMURA, Toru**
**POLYMATECH CO., LTD. R & D CENTR.**
**Tokyo 1140014 (JP)**
• **AOKI, Hisashi**
**POLYMATECH CO., LTD. R & D CENTR.**
**Tokyo 1140014 (JP)**

• **SHIMOYAMA, Naoyuki**
**POLYMATECH CO., LTD. R & Dcentr**
**Tokyo 1140014 (JP)**
• **ISHIGAKI, Tsukasa**
**POLYMATECH CO., LTD. R & D centr**
**Tokyo 1140014 (JP)**
• **OCHI, Mitsukazu**
**5670046 (JP)**
• **HARADA, Miyuki**
**5380052 (JP)**

(74) Representative: **Behnisch, Werner**
**Reinhard-Skuhra-Weise & Partner GbR,**
**Friedrichstrasse 31**
**80801 München (DE)**

Remarks:
A request for correction has been filed pursuant to Rule 88 EPC.

(54) **POLYMER COMPOSITE FORMED ARTICLE, PRINTED WIRING BOARD USING THE FORMED ARTICLE AND METHOD FOR PRODUCING THEM**

(57)    A thermoplastic polymer composite formed article or a thermoplastic polymer composite formed article formed from a thermoplastic polymer or a thermoplastic polymer and a fiber, wherein the fiber is arranged along a first plane and the molecular chains of the thermoplastic polymer or thermoplastic polymer is oriented in the direction intersecting with the first plane, and the molecular chains of the thermoplastic polymer or thermoplastic polymer has a degree ($\alpha$) of orientation in a range of 0.5 or more and less than 1.0, and wherein the thermal expansion coefficients of said formed article in the direction along the first plane and in the direction intersecting with the first plane are both $5 \times 10^{-6}$ to $50 \times 10^{-6}$ (/K), and the difference between the thermal expansion coefficient in the direction along the first plane and the thermal expansion coefficient in the direction intersecting with the first plane is $30 \times 10^{-6}$ (/K) or less.

**Fig. 2**

## Description

TECHNICAL FIELD

The present invention generally relates to a polymer composite formed article having thermal expansion coefficients controlled to be isotropically reduced in both a direction extending along the surface of the formed article and a direction intersecting with said direction and a printed wiring board using the formed article. More specifically, the present invention relates to an epoxy resin composite formed article and a thermoplastic polymer composite formed article each having thermal expansion coefficients controlled to be isotropically reduced in both a direction extending along the surface of the formed article and a direction intersecting with said direction. The present invention also relates to printed wiring boards produced using the epoxy resin composite formed article and the thermoplastic polymer composite formed article.

BACKGROUND ART

Conventionally, polymer composite material formed articles in which functional fibers such as a glass fiber, a carbon fiber, a metal fiber, an aramid fiber, or a polybenzazole fiber are incorporated into a polymer material as a matrix have been widely known.

Meanwhile, polymer compositions including an epoxy resin, or a thermoplastic resin have been generally used as insulating materials for printed wiring boards, and electronic parts such as semiconductor packages to be implemented on the printed wiring boards. In addition to polymer materials such as an epoxy resin and a thermoplastic polymer, various dissimilar materials such as metal and ceramics have been used for those printed wiring boards and electronic parts. Those various dissimilar materials may be joined or arranged to be adjacent to each other in a wiring board or an electronic part. Therefore, when the temperature of the environment surrounding these wiring board or the electronic part changes, a difference in thermal expansion coefficients between the dissimilar materials may causes thermal stress in the wiring board, the electronic part itself, or at an interface between the dissimilar materials thereon. In particular, there is a large difference in thermal expansion coefficients between a polymer material such as an epoxy resin or a thermoplastic polymer for forming a wiring board (a general thermal expansion coefficient at room temperature: $> 5 \times 10^{-5}$ (/K)) and a metal such as copper to be used for a wiring material (a thermal expansion coefficient at room temperature: $1.65 \times 10^{-5}$ (/K)). Therefore, a wiring board or an electronic part composed of a polymer material such as an epoxy resin and a metal may have problems including a cracking, peeling at an interface between a polymer material portion (e.g., epoxy resin) and a metal portion, and breakage or shorting of the wiring due to thermal stress generated.

To cope with the above-mentioned problems, a copper-clad laminate has been generally used as a printed wiring board. Such copper-clad laminate is formed by integrally molding a prepreg and copper foil under heat and pressure, and drying the resultant. The prepreg is obtained by impregnating a base material such as glass cloth with a polymer composition containing an epoxy resin, a thermoplastic polymer, or the like. Furthermore, Japanese Laid-Open Patent Publications No.2002-53646, No.2001-288251, and No.10-145020 each disclose an epoxy resin composition having a reduced thermal expansion coefficient to reduce the thermal expansion coefficient of a substrate material. Japanese Laid-Open Patent Publications No.11-147960 and No.08-255959 each disclose a substrate including a special base material and reinforcing material. Japanese Laid-Open Patent Publications No.10-034742 discloses a liquid crystal polymer laminated body used as a substrate material for a flexible printed wiring board or the like. The laminated body includes an isotropic liquid crystal polymer which has low thermal expansivity and which is oriented at random in a plane to reduce the anisotropy of a thermal expansion coefficient in the plane of the substrate. In addition, substrates blended with a filler having low expansivity such as silica have been proposed.

With the advent of the increase in number of layers, and complication, of printed wiring boards in recent years, it has become important to suppress thermal expansion, particularly in the thickness direction of a printed wiring board for the purpose of, for example, securing through-hole reliability of the boards. In each of such glass cloth-impregnated epoxy printed wiring boards and epoxy printed wiring boards including a special base material and reinforcing material as above-described, thermal expansion in a direction extending along the surface of the printed wiring board can be reduced. However, in contrast, thermal expansion in the thickness direction of the boards increases.

In an epoxy printed wiring board using an epoxy resin composition having a reduced thermal expansion coefficient or an epoxy printed wiring board blended with a filler having low expansivity such as silica, the thermal expansion of the wiring board can be isotropically reduced to some extent, but the reduction is insufficient. For example, Japanese Laid-Open Patent Publication No.2004-175995 discloses a film in which a composition including a blend of a liquid crystal polymer and another thermoplastic polymer is used to reduce the thermal expansion coefficient in the thickness direction.

In an epoxy formed article in which molecular chains of a liquid crystalline epoxy resin are oriented in a specific direction by applying magnetic fields to the resin, thermal expansion in the orientation direction can be reduced, but thermal expansion in any other direction increases.

Therefore, a polymer formed article such as an epoxy resin formed article in which thermal expansion is isotropically reduced in each of a direction extending along the surface of the formed article and a direction perpendicular to the said direction has been strongly demanded.

The present invention has been made to address such problems as above-described. An objective of the present invention is to provide a polymer composite formed article such as an epoxy resin composite formed article in which thermal expansion is isotropically reduced in each of a direction extending along the surface of the formed article and a direction intersecting with said direction and a printed wiring board formed of such polymer composite formed article. Another objective of the present invention is to provide a method of producing the polymer composite formed article such as an epoxy resin composite formed article and a method of producing the printed wiring board formed of the polymer composite formed article.

DISCLOSURE OF THE INVENTION

To address to the problems above, one aspect of the present invention provides an epoxy resin composite formed article composed of an epoxy resin and fibers. In the formed article, the fibers are arranged along a first plane and molecular chains of the epoxy resin are oriented in a direction intersecting with the first plane. A degree of orientation $\alpha$ of the molecular chains of the epoxy resin is in a range of 0.5 or more and less than 1, as determined by the following expression (1) based on X-ray diffraction measurement:

$$\text{Degree of orientation } \alpha = (180 - \Delta\beta/180) \quad (1)$$

wherein $\Delta\beta$ represents a full width at half maximum in an intensity distribution measured in an azimuth angle direction from 0 to 360° at a fixed peak scatter angle in the X-ray diffraction measurement. Each of the thermal expansion coefficients of the epoxy resin composite formed article in the direction along the first plane and in the direction intersecting with the first plane is in a range of $5 \times 10^{-6}$ to $50 \times 10^{-6}$ (/K) and a difference between the thermal expansion coefficients in the direction along the first plane and in the direction intersecting with the first plane is $30 \times 10^{-6}$ (/K) or less. In this case, the thermal expansion coefficients can be controlled to be isotropically small, thereby reducing any damages such as cracks due to thermal expansion.

The epoxy resin is preferably a liquid crystalline epoxy resin having a mesogenic group in its molecular.

The fibers preferably comprise at least one of a fiber cloth and single fibers.

The fibers preferably consist of at least one selected from glass fibers, ceramic fibers, carbon fibers, metal fibers, and organic fibers.

In another aspect, a printed wiring board formed of the epoxy resin composite formed article is provided, wherein an electrically conductive layer is provided on at least one of a surface and inside of the epoxy resin composite formed article.

In still another aspect, a method for producing the epoxy resin composite formed article is provided. The method includes disposing the fibers within a cavity of a mold in such a manner that the fibers are arranged along the first plane, impregnating the fibers with an epoxy resin composition by filling the cavity of the mold with the epoxy resin composition, orienting molecular chains of the epoxy resin in a direction intersecting with the first plane, and curing the epoxy resin composition while the orientation of the molecular chains of the epoxy resin is maintained. According to this method, the epoxy resin composite formed article in which the thermal expansion coefficients are controlled to be isotropically small can be obtained easily.

In the step of orienting the molecular chains of the epoxy resin, the orientation of the molecular chains of the epoxy resin is preferably accomplished by application of a magnetic field thereto.

In another aspect, a method for producing the printed wiring board is also provided. The method includes disposing the fibers within a cavity of a mold in such a manner that the fibers are arranged along the first plane, impregnating the fibers with an epoxy resin composition by filling the cavity of the mold with the epoxy resin composition, orienting molecular chains of the epoxy resin in a direction intersecting with the first plane, curing the epoxy resin composition while the orientation of the molecular chains of the epoxy resin is maintained, and providing an electrically conductive layer on at least one of a surface and inside of the printed wiring board at least either prior to the step of disposing, or after the steps of impregnating, or curing. According to this method, the printed wiring board in which the thermal expansion coefficients are controlled to be isotropically small can be easily obtained.

In the step of orienting, the orientation of the molecular chains of the epoxy resin is preferably accomplished by application of a magnetic field thereto.

In still another aspect, an alternative method for producing the epoxy resin composite formed article. This method includes preparing an epoxy resin composition containing the fibers, filing a cavity of a mold with the epoxy resin composition in such a manner that a major axis of each of the fibers are arranged along the first plane, orienting molecular chains of the epoxy resin in a direction intersecting with the first plane, and curing the epoxy resin composition, while the orientation of the molecular chains of the epoxy resin is maintained. According this method, the epoxy resin formed article in which the thermal expansion coefficients are controlled to be isotropically small can be easily obtained.

In another aspect, a thermoplastic polymer composite formed article composed of a thermoplastic polymer and fibers. In the formed article, the fibers are arranged along a first plane and molecular chains of the thermoplastic polymer are oriented in a direction intersecting with the first plane.

The degree of orientation $\alpha$ of the molecular chains of the thermoplastic polymer is in a range of 0.5 or more and less than 1, as determined by the following expression (1) based on X-ray diffraction measurement,

$$\texttt{Degree of orientation } \alpha = (180-\Delta\beta/180) \quad (1)$$

wherein $\Delta\beta$ represents a full width at half maximum in an intensity distribution measured in an azimuth angle direction from 0 to 360° at a fixed peak scatter angle in the X-ray diffraction measurement.

Each of the thermal expansion coefficients of the thermoplastic polymer composite formed article in the direction along the first plane and in the direction intersecting with the first plane is in a range of $5 \times 10^{-6}$ to $50 \times 10^{-6}$ (/K) and the difference between the thermal expansion coefficients in the direction along the first plane and in the direction intersecting with the first plane is $30 \times 10^{-6}$ (/K) or less. In this case, the thermal expansion coefficients can be controlled to be isotropically small, thereby reducing any damage such as cracks due to thermal expansion.

The thermoplastic polymer is preferably a liquid crystalline polymer having a mesogenic group in its molecular.

The liquid crystalline polymer is preferably at least one selected from aromatic polyester, aromatic polyamide, and aromatic polyesteramide.

The fibers preferably comprise at least one of a fiber cloth and single fibers.

The fibers preferably consist of at least one selected from glass fibers, ceramic fibers, carbon fibers, metal fibers, and organic fibers.

In an another aspect, a printed wiring board formed of the thermoplastic polymer composite formed article is provided, wherein an electrically conductive layer is provided on at least one of a surface and inside of the thermoplastic polymer composite formed article.

In still another aspect, a method for producing the thermoplastic polymer composite formed article is provided. This method includes disposing the fibers within a cavity of a mold in such a manner that the fibers are arranged along the first plane, impregnating the fibers with an thermoplastic polymer composition by filling the cavity of the mold with the thermoplastic polymer composition, orienting molecular chains of the thermoplastic polymer in a direction intersecting with the first plane, and solidifying the thermoplastic polymer composition while the orientation of the molecular chains of the thermoplastic polymer is maintained.

In another aspect, an alternative method for producing the thermoplastic polymer composite formed article is provided. This method includes forming a preform of a thermoplastic polymer composition containing the thermoplastic polymer, disposing the preform and the fibers within a cavity of a mold in such a manner the preform and the fibers are arranged along the first plane, impregnating the fibers with an thermoplastic polymer composition by melting the preform, orienting molecular chains of the thermoplastic polymer in a direction intersecting with the first plane, and solidifying the thermoplastic polymer composition while the orientation of the molecular chains of the thermoplastic polymer is maintained.

In another aspect, an alternative method for producing the thermoplastic polymer composite formed article is provided. This method includes preparing an thermoplastic polymer composition containing the thermoplastic polymer and the fibers, filing a cavity of a mold with the thermoplastic polymer composition in such a manner that a major axis of each of the fibers is arranged along the first plane, orienting molecular chains of the thermoplastic polymer in a direction intersecting with the first plane, and solidifying the thermoplastic polymer composition, while the orientation of the molecular chains of the thermoplastic polymer is maintained. According to these methods, a thermoplastic polymer composite formed article in which the thermal expansion coefficients are controlled to be isotropically small can be easily obtained.

In the step of orienting the molecular chains of the thermoplastic polymer in the direction intersecting with the first plane, the orientation of the molecular chains of the thermoplastic polymer is preferably accomplished by application of a magnetic field thereto.

In another aspect, a method for producing the printed wiring board is provided. This method includes disposing the fibers within a cavity of a mold in such a manner that the fibers are arranged along the first plane, impregnating the fibers with an thermoplastic polymer composition by filling the cavity of the mold with the thermoplastic polymer composition, orienting molecular chains of the thermoplastic polymer in a direction intersecting with the first plane, solidifying the thermoplastic polymer composition while the orientation of the molecular chains of the thermoplastic polymer is maintained, and providing an electrically conductive layer on at least one of a surface and inside of the printed wiring board at least either prior to the step of disposing, or after the steps of impregnating, or solidifying.

In still another aspect, an alternative method for producing the printed wiring board is provided. This method includes forming a preform of a thermoplastic polymer composition containing the thermoplastic polymer, disposing the preform and the fibers within a cavity of a mold in such a manner the preform and the fibers are arranged along the first plane, impregnating the fibers with an thermoplastic polymer composition by melting the preform, orienting molecular chains of the thermoplastic polymer in a direction intersecting with the first plane, solidifying the thermoplastic polymer composition while the orientation of the molecular chains of the thermoplastic polymer is maintained, and providing an electrically conductive layer on at least one of a surface and inside of the printed wiring board at least either prior to the step of disposing, or after the steps of impregnating, or solidifying.

In another aspect, an alternative method for producing the printed wiring board is provided. This method includes preparing a thermoplastic polymer composition containing the thermoplastic polymer and the fibers, filing a cavity of a mold with the thermoplastic polymer composition in such a manner that a major axis of each of the fibers are arranged along the first plane, orienting molecular chains of the thermoplastic polymer in a direction intersecting with the first plane, solidifying the thermoplastic polymer composition, while the orientation of the molecular chains of the thermoplastic polymer is maintained, and providing an electrically conductive layer on at least one of a surface and inside of the printed wiring board at least either prior to the step of disposing, or after the steps of impregnating, or solidifying. According to these methods, a printed wiring board in which thermal expansion coefficients are controlled to be isotropically small can be easily obtained.

In the step of orienting the molecular chains of the thermoplastic polymer in the direction intersecting with the first plane, the orientation of the molecular chains of the thermoplastic polymer is accomplished by application of a magnetic field thereto.

In another aspect, a polymer composite formed article composed of a polymer and fibers is provided. In this formed article, the fibers are arranged along a first plane and molecular chains of the polymer are oriented in a direction intersecting with the first plane.

The degree of orientation $\alpha$ of the molecular chains of the polymer is in a range of 0.5 or more and less than 1, as determined by the following expression (1) based on X-ray diffraction measurement,

$$\text{Degree of orientation } \alpha = (180-\Delta\beta/180) \quad (1)$$

wherein $\Delta\beta$ represents a full width at half maximum in an intensity distribution measured in an azimuth angle direction from 0 to 360° at a fixed peak scatter angle in the X-ray diffraction measurement.

Each of the thermal expansion coefficients of the polymer composite formed article in the direction along the first plane and in the direction intersecting with the first plane is in a range of $5 \times 10^{-6}$ to $50 \times 10^{-6}$ (/K) and a difference between the thermal expansion coefficients in the direction along the first plane and in the direction intersecting with the first plane is $30 \times 10^{-6}$ (/K) or less. In this case, the thermal expansion coefficients are controlled to be isotropically small, thereby reducing any damages such as cracks due to thermal expansion.

BRIEF DESCRIPTION OF THE DRAWINGS

Figure 1 is a perspective view showing an epoxy resin composite formed article of a first embodiment and a thermoplastic polymer composite formed article of a third embodiment.

Figure 2 is a sectional view showing the epoxy resin composite formed article of the first embodiment.

Fig. 3 is a sectional view showing a printed wiring board of a second embodiment.

Figure 4 is an X-ray diffraction pattern showing an X-ray diffraction intensity distribution in the radial direction of a debye ring of an epoxy resin composition component of the epoxy resin composite formed article.

Figure 5 is a graph showing an intensity distribution in the azimuth angle direction of the epoxy resin composition component of the epoxy resin composite formed article.

Figure 6 is a schematic view showing a method of producing the epoxy resin composite formed article of the first embodiment.

Figure 7 is a schematic view showing the method of producing the epoxy resin composite formed article of the first embodiment.

Figure 8 is a schematic view showing the method of producing the epoxy resin composite formed article of the first embodiment.
Figure 9 is a schematic view showing a method of producing the printed wiring board of the second embodiment.
Figure 10 is a schematic view showing the method of producing the printed wiring board of the second embodiment.
Figure 11 is a sectional view showing the thermoplastic polymer composite formed article of the third embodiment.
Figure 12 is a sectional view showing a printed wiring board of a fourth embodiment.
Figure 13 is a schematic view showing a method of producing the thermoplastic polymer composite formed article of the third embodiment.
Figure 14 is a schematic view showing the method of producing the thermoplastic polymer composite formed article of the third embodiment.

BEST MODE FOR CARRYING OUT THE INVENTION

Hereinafter, the best mode for carrying out the present invention will be described in detail.

The present invention provides a polymer composite formed article composed of a polymer and fibers. In the polymer composite formed article, the fibers are arranged along a first plane, and the molecular chains of the polymer are oriented in a direction intersecting with the first plane, whereby a thermal expansion coefficient is reduced in each direction.

(First embodiment)

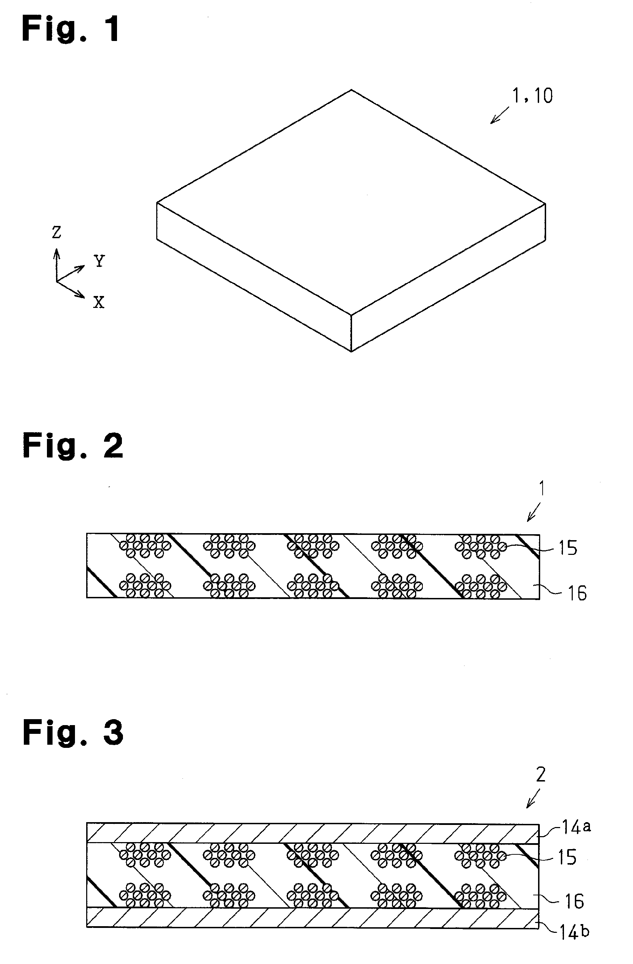

With reference to Figs. 1 and 2, an epoxy resin composite formed article 1 according to a first embodiment of the present invention will be described. The epoxy resin composite formed article 1 has a plate-like shape, and is formed of an epoxy resin composition 16 and a plurality of fiber cloths 15. In the epoxy resin composite formed article 1, each fiber cloth 15 is a cloth constructed from a great number of single fibers. Each fiber cloth 15 is arranged in the epoxy resin composition 16 to be parallel with a first plane, that is, a surface of the formed article 1. In the epoxy resin composite formed article 1 of this embodiment, the molecular chains of an epoxy resin in the epoxy resin composition 16 are oriented in the direction perpendicular to the first plane, namely, in the thickness direction (Z direction in Fig. 1) of the formed article 1. In other words, the molecular chains of the epoxy resin are arranged to be perpendicular to each fiber cloth 15.

In this embodiment, discrete single fibers may be used in addition to or as an alternative to the fiber cloths 15.

In this case, for example, the single fibers are oriented in such a manner that each fiber axis of the single fibers is parallel to the surface of the epoxy resin composite formed article 1 (for example, the X and Y directions of Fig. 1) and preferably directed in a random direction respectively, while the molecular chains of the epoxy resin are oriented in the thickness direction of the formed article 1 (the Z direction of Fig. 1).

(Second embodiment)

With reference to Fig. 3, a printed wiring board 2 according to a second embodiment of the present invention embodied using the epoxy resin composite formed article 1 will be described. The printed wiring board 2 includes an epoxy resin composite formed article 1 formed in the same manner as in the first embodiment and conductive layers 14a and 14b formed on the upper and lower surfaces of the formed article 1 so as to sandwich the formed article 1 therebetween. In the epoxy resin composite formed article 1, the fiber cloths 15 are arranged to be parallel with the surface of the wiring board 2. In the epoxy resin composite formed article 1, the molecular chains of the epoxy resin are oriented in the direction perpendicular to the surface of the wiring board 2, that is, in the thickness direction of the wiring board 2.

In this embodiment as well, single fibers may be used in addition to or as an alternative to the fiber cloths 15. In this case, as in the case of the first embodiment, the single fibers are oriented in such a manner that each fiber axis is parallel to the surface of the epoxy resin composite formed article 1 (for example, the X and Y directions of Fig. 1) and preferably, directed in a random direction respectively, while the molecular chains of the epoxy resin are oriented in the thickness direction of the formed article 1 (the Z direction of Fig. 1).

(Third embodiment)

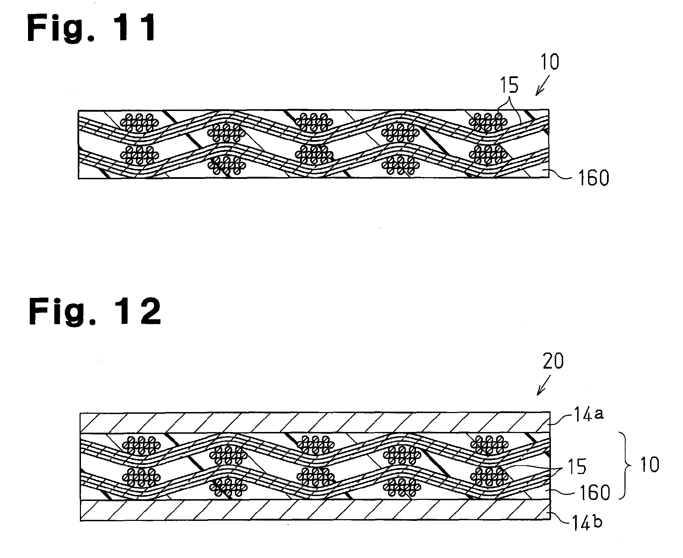

With reference to Figs. 1 and 11, a thermoplastic polymer composite formed article 10 according to a third embodiment of the present invention will be described. The thermoplastic polymer composite formed article 10 has a plate-like shape. The formed article 10 is formed of a thermoplastic polymer composition 160 and a plurality of fiber cloths 15. In the thermoplastic polymer composite formed article 10, each fiber cloth 15 is a cloth composed of a great number of single fibers. Each fiber cloth 15 is arranged in the thermoplastic polymer composition 160 to be parallel with a first plane, that is, the surface of the formed article 10 in this embodiment. In the thermoplastic polymer composite formed article 10, the molecular chains of a thermoplastic polymer in the thermoplastic polymer composition 160 are oriented in the direction perpendicular to the first plane, i.e., in the thickness direction of the formed article (the Z direction of Fig. 1) in this embodiment. In other words, the molecular chains of the thermoplastic polymer are arranged to be perpendicular to each fiber cloth 15.

In this embodiment, discrete single fibers may be used in addition to or as an alternative to the fiber cloths 15.

In this case, for example, the single fibers are oriented in such a manner that each fiber axis is parallel to the surface of the thermoplastic polymer composite formed article 10 and preferably, directed in a random direction respectively, while the molecular chains of the thermoplastic polymer are oriented in the thickness direction of the formed article 10 (the Z direction of Fig. 1).

(Fourth embodiment)

With reference to Fig. 12, a printed wiring board 20 according to a fourth embodiment of the present invention embodied using the thermoplastic polymer composite formed article 10 will be described. The printed wiring board 20 includes the thermoplastic polymer composite formed article 10 formed in the same manner as in the first embodiment and the conductive layers 14a and 14b formed on the upper and lower surfaces of the formed article 10 so as to sandwich the formed article 10 between them. In the thermoplastic polymer composite formed article 10, the fiber cloths 15 are arranged parallel to the surface of the wiring board 20. In the thermoplastic polymer composite formed article 10, the molecular chains of the thermoplastic polymer is oriented in the direction perpendicular to the surface of the wiring board 20, i.e. in the thickness direction of the wiring board 20.

In this embodiment, discrete single fibers may be also used in addition to or as an alternative to the fiber cloths 15. In this case, as in the case of the third embodiment, the single fibers are oriented in such a manner that each fiber axis is in parallel with the surface of the thermoplastic polymer composite formed article 10 and preferably, directed in a random direction respectively, while the molecular chains of the thermoplastic polymer are oriented in the thickness direction of the formed article 10 (the Z direction of Fig. 1).

In each of the second and fourth embodiments, the printed wiring board requires high electrical insulating property in an insulator portion thereof. Therefore, the fiber cloths and the single fibers arranged in the epoxy resin composite formed article 1 and the thermoplastic polymer composite formed article 10 are preferably insulative. A layer capable of forming an electrical circuit such as metal foil, a metal-plated layer, or a conductive paste layer can be used for each of the conductive layers 14a and 14b.

In the epoxy resin composite formed article 1 and the thermoplastic polymer composite formed article 10 of the first to fourth embodiments, the degree of orientation $\alpha$ of the molecular chains of the epoxy resin or the thermoplastic polymer is in a range of 0.5 or more and less than 1.0. The degree of orientation $\alpha$ is determined by the following expression (1) based on the X-ray diffraction measurement.

$$\texttt{Degree of orientation } \alpha \ = \ (180 \ - \ \Delta\beta)/180 \cdots (1)$$

wherein $\Delta\beta$ represents a full width at half maximum in an intensity distribution measured in an azimuth angle direction from 0 to 360° at a fixed peak scatter angle in the X-ray diffraction measurement.

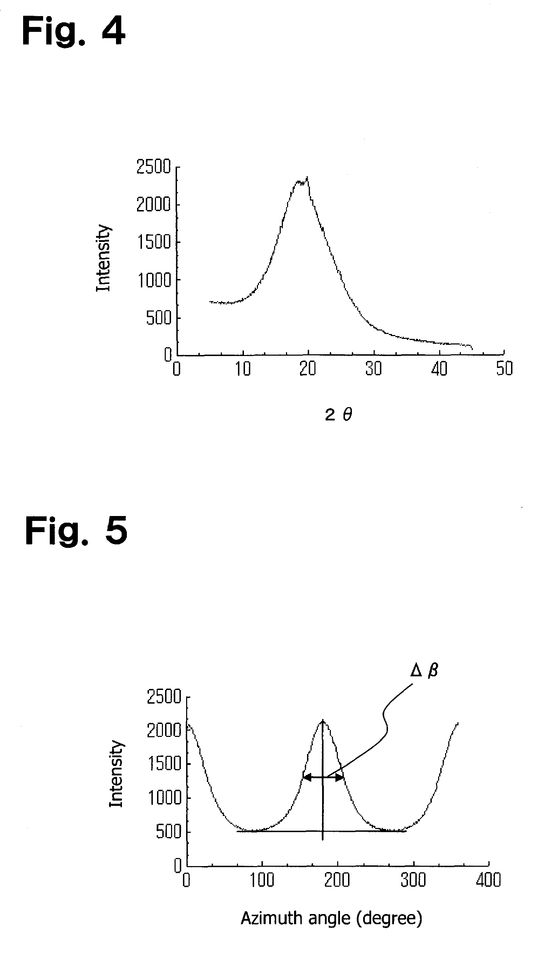

In order to determine the degree of orientation $\alpha$, the epoxy resin composite formed article 1 or the thermoplastic polymer composite formed article 10 is subjected to wide-angle X-ray diffraction measurement (transmission). When a sample is irradiated with an X-ray in an X-ray diffraction instrument, a concentric arc-like diffraction pattern (debye ring) is obtained if any particles (molecular chains) in the sample are oriented. Firstly, a diffraction pattern showing an X-ray diffraction intensity distribution in the radial direction from the center of such debye ring is obtained for the sample of the formed article (see Fig. 4). In this diffraction pattern, the axis of abscissa indicates an angle 2θ twice as large as the diffraction angle θ of an X-ray. A peak observed at the position of 2θ = 20° is considered to show a distance between molecular chains of a solid epoxy resin or thermoplastic polymer .

The angle at which the diffraction peak of the epoxy resin or the thermoplastic resin (peak scatter angle) appears is generally around 20°, although the angle may range from about 15° to 30° depending on a difference in structure of the epoxy resin or the thermoplastic resin or on a difference in constituents of the epoxy resin composition or the thermoplastic resin composition. An X-ray diffraction intensity distribution in the azimuth angle direction (the circumferential direction of the debye ring) from 0° to 360° is measured, while the measurement angle in the radial direction is fixed at the angle (peak scatter angle) at which the diffraction peak occurs. Thereby, such an X-ray diffraction intensity distribution in the azimuth angle direction at the peak scatter angle as shown in Fig. 5 can be obtained. A sharper peak in the intensity distribution means that the molecular chains of the epoxy resin or the thermoplastic resin are more highly oriented in a fixed direction. Therefore, a width of the peak at half height (full width at half maximum $\Delta\beta$) is determined

in the intensity distribution in the azimuth angle direction. Then, the full width at half maximum $\Delta\beta$ is substituted into the expression (1). Thereby, the degree of orientation $\alpha$ of the molecular chain of the epoxy resin or the thermoplastic polymer can be calculated. The degree of orientation $\alpha$ is 0.72 in the case of the intensity distribution in the azimuth angle direction shown in Fig. 5.

To obtain an effect as expected from the present invention with improved efficiency, the value for the degree of orientation $\alpha$ is in a range of 0.5 or more and less than 1.0, preferably 0.55 or more and less than 1.0, more preferably 0.6 or more and less than 1.0, or still more preferably 0.7 or more and less than 1.0. However, a range for the degree of orientation $\alpha$ varies depending on the extent to which a thermal expansion coefficient must be reduced. In an epoxy resin composite formed article and a thermoplastic polymer composite formed article, the degree of orientation $\alpha$ of the molecular chains of each of an epoxy resin and a thermoplastic polymer within the above ranges can significantly reduce the thermal expansion coefficient in the orientation direction of each formed article.

When the degree of orientation $\alpha$ in each of the epoxy resin composite formed article and the thermoplastic polymer composite formed article of the present invention is less than 0.5, the thermal expansion coefficient of each of the formed articles is not reduced enough to obtain sufficient effects. Meanwhile, the degree of orientation $\alpha$ cannot be equal to or more than 1.0 in the expression (1) because the full width at half maximum $\Delta\beta$ always has a positive value.

Each of the thermal expansion coefficients of the epoxy resin composite formed article 1 and the thermoplastic polymer composite formed article 10 in the direction parallel to the first plane, namely, the surface of the formed articles 1, 10 and in the direction perpendicular to the first plane is in a range of $5 \times 10^{-6}$ to $50 \times 10^{-6}$ (/K), or more preferably $10 \times 10^{-6}$ to $40 \times 10^{-6}$ (/K), and a difference between the thermal expansion coefficients in the direction along the first plane and in the direction perpendicular to the first plane is $30 \times 10^{-6}$ (/K) or less.

In the epoxy resin composite formed article 1 or the thermoplastic polymer composite formed article 10, the fiber cloths 15 (or the single fibers) are arranged to be parallel to the surface of the formed article (the first plane), and the molecular chains of the epoxy resin or the thermoplastic polymer are oriented in the direction perpendicular to the surface of the formed article, i.e. the thickness direction of the formed article. The molecular chains of the epoxy resin or the thermoplastic polymer as a matrix of the formed article 1 or 10 are oriented in the direction intersecting with the fiber cloths 15 (or the single fibers) in this way. Thereby, thermal expansion can be reduced in both the direction in which the fiber cloths 15 (or the single fibers) extend (i.e. the direction along the surface) and the direction intersecting with said direction in which the molecular chains of the epoxy resin or the thermoplastic polymer extend (i.e. the thickness direction). In addition, the molecular chains of the epoxy resin or the thermoplastic polymer are extremely small as compared to the fibers constructing the fiber cloths 15 or gaps between the fibers, so the orientation of the molecular chains is hardly inhibited by the fiber cloths 15 (or single fibers). Accordingly, the fiber cloths 15 (or single fibers) can be incorporated at a high density into the formed article.

The epoxy resin composite formed article 1 and the thermoplastic polymer composite formed article 10 are applicable to insulating materials for various composite materials, printed wiring boards, semiconductor packages, casings, and the like. As a result, in the various electronic parts, problems due to a difference in thermal expansion between the epoxy resin or the thermoplastic polymer material and any other material including cracks, peeling of an interface, and breakage or short of circuit wirings, and reductions in properties of the electronic parts in association with the problems can be reduced.

In addition, the printed wiring boards 2 and 20 in the second and fourth embodiments are each characterized in that the conductive layers 14a and 14b are formed on both surfaces of the epoxy resin composite formed article 1 or the thermoplastic polymer composite formed article 10 as an insulator to form the boards 2, 20. Each of the printed wiring boards 2 and 20 can reduce problems due to a difference in thermal expansion between each of the conductive layers 14a, 14b and the insulator (the epoxy resin composite formed article 1 or the thermoplastic polymer composite formed article 10) such as cracks, peeling of an interface, and breakage and short of circuit wirings, and reductions in properties in association with the problems, and can improve through-hole stability.

Hereinafter, the respective constituents of the epoxy resin composite formed article 1 and the thermoplastic polymer composite formed article 10 of the present invention will be described in detail.

<Epoxy resin>

Examples of an epoxy resin used in an epoxy resin composition include a bisphenol type, a novolac type, a naphthalene type, a triphenol alkane type, a biphenyl type, acyclic aliphatic epoxy resins, and halides or hydrides thereof. Each of those epoxy resins may be used alone, or two or more of them may be used in combination. Furthermore, among of those epoxy resins, a liquid crystalline epoxy resin having a mesogenic group in a molecule is particularly preferably used for the epoxy resin composite formed article. Liquid crystallinity of the liquid crystalline epoxy resin having a mesogenic group can facilitate to orient the molecular chains of the epoxy resin, and control the degree of orientation of the epoxy resin. The content of the liquid crystalline epoxy resin having a mesogenic group in a molecule in the total epoxy resins contained in the epoxy resin composition is preferably, but not particularly limited to, 50 wt% or more.

A liquid crystalline epoxy resin having a mesogenic group in the main chain of the molecule is a particularly preferable. The term "mesogenic group" refers to a functional group capable of exhibiting liquid crystallinity. Specific examples of the group include biphenyl, cyanobiphenyl, terphenyl, cyanoterphenyl, phenyl benzoate, azobenzene, azomethine, azoxybenzene, stilbene, phenyl cyclohexyl, biphenyl cyclohexyl, phenoxyphenyl, benzylideneaniline, benzyl benzoate, bipyridine, phenyl pyrimidine, phenyl dioxane, benzoyl aniline, tolan, and derivatives thereof.

The number of mesogenic groups in a molecular chain of an epoxy resin is at least one, and may be two or more. The liquid crystalline epoxy resin may also include a soft structure portion called a bent chain (spacer), which is composed of, for example, an aliphatic hydrocarbon group, an aliphatic ether group, an aliphatic ester group, a siloxane bond between the mesogenic groups.

Such liquid crystalline epoxy resin exhibits a liquid crystal state in a certain temperature range, and has a property that some of the mesogenic groups tend to be regularly arranged. The liquid crystallinity can be confirmed by exhibition of strong birefringence inherent in a liquid crystal obtained in an ordinary polarization test using an orthogonal polarizer. The liquid crystalline epoxy resin may exhibit any kind of the liquid crystal states including nematic, smectic, cholesteric, and discotic states. The liquid crystalline epoxy resin having a mesogenic group and another epoxy resin containing no mesogenic group may be mixed for use.

<Thermoplastic polymer>

A liquid crystal thermoplastic polymer having a mesogenic group in a molecule is preferably used as a thermoplastic polymer in a thermoplastic polymer composition. The liquid crystallinity of the liquid crystal thermoplastic polymer having a mesogenic group in a molecule can facilitate orientation of the molecular chains of the thermoplastic polymer and control the degree of orientation of the thermoplastic polymer. The content of the liquid crystal thermoplastic polymer having a mesogenic group in a total amount of the thermoplastic polymers contained in the composition is preferably, but not particularly limited to, 50 wt% or more.

A liquid crystal polymer having a mesogenic group in the main chain of a molecule (a main chain type liquid crystal polymer) is a particularly preferable for use. The term "mesogenic group" refers to a functional group capable of exhibiting liquid crystallinity. Specific examples of the group include biphenyl, cyanobiphenyl, terphenyl, cyanoterphenyl, phenyl benzoate, azobenzene, azomethine, azoxybenzene, stilbene, phenyl cyclohexyl, biphenyl cyclohexyl, phenoxyphenyl, benzylideneaniline, benzyl benzoate, bipyridine, phenyl pyrimidine, phenyl dioxane, benzoyl aniline, tolan, and derivatives thereof.

The number of mesogenic groups in a molecular chain of the liquid crystal thermoplastic polymer is at least one, and may be two or more. The liquid crystal thermoplastic polymer also may include a soft structure portion called a bent chain (spacer), which is composed of, for example an aliphatic hydrocarbon group, an aliphatic ether group, an aliphatic ester group, and a siloxane bond, between mesogenic groups.

A thermal liquid crystal polymer is a specific example of the liquid crystal thermoplastic polymer.

The term of "thermal liquid crystal polymer" refers to a liquid crystal polymer which has thermoplasticity and which exhibits a liquid crystal state showing optical anisotropy within a predetermined temperature range when melted by heating. Examples of the thermal liquid crystal polymer include polyester, polyamide, polyesteramide, polyether ketone, polycarbonate, and polyimide. Each of those polymers may be used alone, or two or more them may be used in combination.

Such liquid crystal thermoplastic polymer is in a liquid crystal state in a predetermined temperature range, and has a property that some of the mesogenic groups tend to be regularly arranged. The liquid crystallinity can be confirmed by exhibition of strong birefringence inherent in a liquid crystal obtained in an ordinary polarization test using an orthogonal polarizer. The liquid crystal thermoplastic polymer may exhibit any kind of the liquid crystal states including nematic, smectic, cholesteric, and discotic states. A liquid crystal thermoplastic polymer having a mesogenic group in a molecule and a thermoplastic polymer containing no mesogenic group in a molecule may be mixed and used.

<Fiber>

The fibers to be used for the epoxy resin composite formed article 1 and the thermoplastic polymer composite formed article 10 of the present invention are a fiber cloth or an aggregation of discrete single fibers (simply referred to as "single fibers") . The fiber length and fiber diameter of a single fiber in a fiber cloth or group of single fibers to be used, and the weave density of fibers in a fiber cloth are not particularly limited. However, in consideration of the productivity, handling, and ease of blending into an epoxy resin composition and a thermoplastic polymer composition of a single fiber, the diameter of a single fiber is practically preferably 0.1 to 30 $\mu$m, and the weave density of fibers in a fiber cloth is preferably about 5 to 50 fibers/25 mm for each of a weft and a warp. Each of fibers in a fiber cloth may be woven to be spaced apart from each other in such a manner that the fiber cloth can be easily impregnated with the epoxy resin composition and the thermoplastic polymer composition. A ratio between the numbers of warps and wefts to be knitted may be appropriately adjusted. In addition, the fiber cloth may be a woven or non-woven fabric obtained by fixing fibers with a polymer resin, such as a felt cloth. Although the kinds of single fibers constituting the fiber cloth and the aggregation of single fibers are not particularly limited, at least one selected from glass fibers, carbon fibers, metal fibers, ceramic fibers, and organic fibers is preferable.

When the value for the anisotropic diamagnetic susceptibility $\chi_a$ of a fiber is large, the fiber receives a large force in a direction parallel with or perpendicular to a line of magnetic force in a magnetic field. The anisotropic diamagnetic susceptibility $\chi_a$ is a value showing the anisotropy of a diamagnetic susceptibility generated by applying an external magnetic field, the value being obtained by subtracting a susceptibility $\chi\perp$ in the direction perpendicular to the fiber axis of the fiber from a susceptibility $\chi''$ in the direction of the fiber axis. A fiber in which the anisotropic diamagnetic susceptibility $\chi_a$ has a positive value such as a carbon fiber, an aramid fiber, or a polybenzazole fiber receives a force such that each fiber axis is aligned parallel to lines of magnetic force M in a magnetic field. The molecular chains of a main chain type liquid crystalline epoxy resin and a main chain type liquid crystal thermoplastic polymer also receives a force such that their axes are aligned parallel to the lines of magnetic force M in a magnetic field. As a result, these molecular chains are oriented in the direction parallel to the lines of the magnetic force.

As described above, the molecular chains of an epoxy resin and a thermoplastic polymer also tends to be oriented parallel to lines of magnetic force M. Therefore, when fibers having the anisotropic diamagnetic susceptibility $\chi_a$ in a positivevalue are used and the molecular chains of an epoxy resin or a thermoplastic polymer are oriented by a magnetic field, attention must be paid to prevent the fibers from being oriented by the magnetic field in the same direction as the orientation direction of the molecular chains of the epoxy resin or the thermoplastic polymer. Examples of a method for the prevention include use of fibers hardly oriented by a magnetic field, that is, fibers in which the anisotropic diamagnetic susceptibility $\chi_a$ itself is small; long fibers, aggregated and assembled fibers, or fibers having a high specific gravity that require larger force to be oriented; and the use of an epoxy resin composition or thermoplastic polymer composition having high viscosity.

In addition, a fiber cloth and single fibers may be used in combination. Furthermore, two or more kinds of fiber cloths or single fibers may be used together. As long as at least one kind of fiber cloth or single fibers among the fiber cloths and the single fibers are arranged in a direction intersecting with the orientation direction of the molecular chains of the epoxy resin or the thermoplastic polymer, the other fiber cloths or single fibers may not be oriented, or may be arranged in the same direction as the orientation direction of the molecular chains of the epoxy resin or the thermoplastic polymer.

<Epoxy resin composition>

The epoxy resin composition 16 for forming the epoxy resin composite formed article 1 contains epoxy resin as above-described, and arbitrarily at least one of a fiber cloth and a set of single fibers. The epoxy resin composition may be added with a curing agent for the purpose of curing the epoxy resin through any reaction. The kind and amount of curing agent to be added as well as conditions for heat curing, photo-curing, and moisture curing are not particularly limited. For example, ordinary amine-based curing agents, acid anhydride-based curing agents, phenol-based curing agents, latent curing agents, polymercaptan-based curing agents, polyaminoamide-based curing agents, isocyanates, block isocyanate, or the like can be used. Each of those curing agents may be used alone, or two or more of them may be used as a mixture. The content of each of those curing agents is typically the same as the amount of the curing agent to be used.

Epoxy groups of the epoxy resin may be self-polymerized without blending of any curing agent. In this case, a polymerization initiator is added to the epoxy resin composition.

The epoxy resin to be used in the present invention can be polymerized through a cationic polymerization using any one of acids such as $AlCl_3$, $SnCl_4$, $TiCl_4$, $BF_3$, $PCl_5$, $SbF_5$ and salts thereof as a polymerization initiator. Similarly, the epoxy resin can be polymerized through an anionic polymerization using an ammonium salt such as tetrabutyl ammonium bromide or dimethyl dibenzyl ammonium chloride as a polymerization initiator.

The epoxy resin composition may contain a small amount of another reaction curable resin in addition to the epoxy resin.

<Thermoplastic polymer composition>

The thermoplastic polymer composition 160 for forming the thermoplastic polymer composite formed article 10 contains the thermoplastic polymer as above-described. Furthermore, the thermoplastic polymer composition 160 may contain at least one of a fiber cloth and a set of single fibers.

Each of the epoxy resin composition and the thermoplastic polymer composition can be blended with an appropriate amount of a filler for additionally reducing the expansion coefficient of each epoxy resin composite formed article and the thermoplastic polymer composite formed article and for improving various properties such as fracture toughness, flexural strength, dielectric constant, and thermal conductivity. Examples of the fillers include metals, metal oxides, metal nitrides, metal carbides, metal hydroxides, metal carbonate compounds, metal-coated resins, resin fillers, carbon fibers, glass fibers, glass beads, carbon-based materials, talc, and clay. Examples of the metals include silver, copper, gold, platinum, and zircon. Examples of the metal oxides include silicon oxide, aluminum oxide, and magnesium oxide. Examples of the metal nitrides include boron nitride, aluminum nitride, and silicon nitride. An example of the metal carbides includes silicon carbide. Examples of the metal hydroxides include aluminum hydroxide and magnesium hydroxide. The filler may be subjected to a treatment with a typical coupling agent for the purposes of improving wettability between the epoxy resin or the thermoplastic polymer and the filler, reinforcing the interface between the epoxy resin or the thermoplastic polymer and the filler, and promoting the dispersion of the fillers into the epoxy resin or the thermoplastic polymer.

It should be noted that each of the epoxy resin composition and the thermoplastic polymer composition can be added with a curing accelerator, a curing retardant, a reinforcement, a stress-lowering agent such as rubbers or elastomers, a pigment, a dye, a fluorescent bleach, a dispersant, a stabilizer, a UV absorber, an energy quencher, an antistatic agent, an antioxidant, a thermal stabilizer, a lubricant, a flame retardant, a defoaming agent, a plasticizer, a solvent, or the like, as required.

Next, the methods for producing the epoxy resin composite formed article 1, the thermoplastic polymer composite formed article 10, and the printed wiring boards 2, 20 will be described.

The epoxy resin composite formed article 1 is formed by: arranging the fiber cloths 15 along a first plane (for example, the surface of the formed article 1) in the epoxy resin composition 16; and curing the epoxy resin composition 16 in a state where the molecular chains of an epoxy resin in the composition 16 are oriented in the direction intersecting with the first plane (for example, the thickness direction of the formed article 1).

The thermoplastic polymer composite formed article 10 is formed by: arranging the fiber cloths 15 along a first plane (for example, the surface of the formed article 10) in the thermoplastic polymer composition 160; and solidifying the thermoplastic polymer composition 160 in a state where the molecular chains of a thermoplastic polymer in the composition 160 are oriented in the direction intersecting with the first plane (forexample, the thickness direction of the formed article 10).

A device capable of molding an epoxy resin and a thermoplastic polymer such as a transfer molding device, a press molding device, a cast molding device, an injection molding device, or an extrusion molding device can be used as a molding device. The epoxy resin composition 16 and the thermoplastic polymer composition 160 can be molded into an epoxy resin composite formed article and a thermoplastic polymer composite formed article in any one of various shapes including a sheet, a film, a block, a granular shape, a rod, a tubular, and a fibrous shape.

An example of a method of orienting the molecular chains of each of the epoxy resin and the thermoplastic polymer in the compositions 16 and 160 includes a method involving orienting the molecular chains by means of at least one selected from rubbing, stretching, rolling, a flow field, a shear field, a magnetic field, and an electric field prior to or upon curing/solidification of the compositions. Of those orientation methods, an orientation method by means of a magnetic field is preferable because the direction in which the molecular chains of the epoxy resin and the thermoplastic polymer are orientedcanbeeasilycontrolled. Theapplicationofamagnetic field to the epoxy resin or the thermoplastic polymer causes their molecular chains to be oriented parallel to lines of magnetic force M. Some of the orientation processes above-described can be used together as required.

Examples of a magnetic field generator device for generating a magnetic field include a permanent magnet, an electromagnet, a superconducting magnet, and a coil. Of those magnetic field generators, a superconducting magnet is preferable because it can generate a magnetic field having a practical magnetic flux density.

The magnetic flux density of a magnetic field to be applied to the epoxy resin composition is preferably 0.2 to 20 tesla (T), more preferably 0.5 to 15 T, or most preferably 1 to 10 T. A magnetic flux density of less than 0.2 T cannot sufficiently orient the rigid molecular chains of an epoxy resin, resulting in an insufficient reduction in thermal expansion coefficient. On the other hand, a magnetic field having a magnetic flux density in excess of 20 T is hardly obtained in practical use. A magnetic flux density in a range of 0.2 to 20 T provides an epoxy resin composite formed article having a low thermal expansion coefficient and is practical.

The magnetic flux density of a magnetic field to be applied to the thermoplastic polymer composition is preferably 1 to 20 tesla (T), more preferably 2 to 15 T, or most preferably 3 to 10 T. A magnetic flux density of less than 1 T cannot sufficiently orient the molecular chains of a thermoplastic polymer, resulting in an insufficient reduction in thermal expansion coefficient. On the other hand, a magnetic field having a magnetic flux density in excess of 20 T is hardly obtained in practical use. A magnetic flux density in a range of 1 to 20 T provides a thermoplastic polymer composite formed article having a low thermal expansion coefficient and is practical.

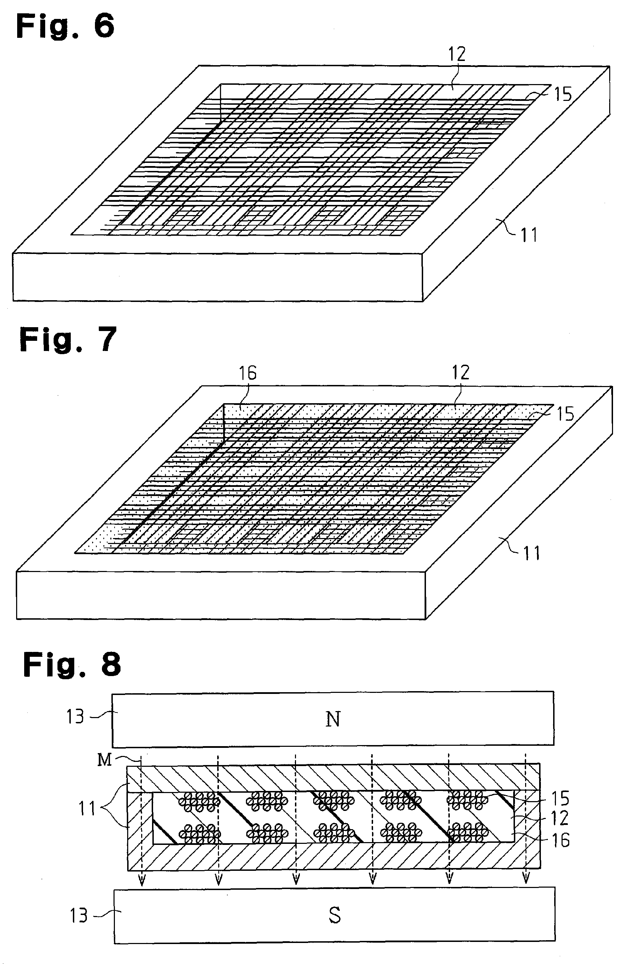

Next, specific methods for producing the epoxy resin composite formed article 1, the thermoplastic polymer composite formed article 10, and the printed wiring boards 2 and 20 will be described in detail with reference to Figs. 6 to 10, and Figs. 13 and 14.

At first, a method for producing the epoxy resin composite formed article 1 formed into a plate-like shape according to the first embodiment, as shown in Fig. 2, will be described. In Fig. 6, a mold 11 is provided with a cavity 12 having a shape corresponding to the desired shape of a formed article. At first, as shown in Fig. 6, one fiber cloth 15 is disposed in the cavity 12 such that the fiber cloth 15 is arranged along, or preferably parallel to, the bottom surface of the cavity 12. Next, as shown in Fig. 7, the cavity 12 is filled with the epoxy resin composition 16. At this time, after multiple fiber cloths 15 have been disposed within the cavity in a stacked manner, the epoxy resin composition 16 may be flowed into the cavity to impregnate the multiple fiber cloths 15 with the epoxy resin composition 16. Alternatively, after one fiber cloth 15 has been di-sposed in the cavity, the epoxy resin composition 16 may be injected into the cavity to impregnate the fiber cloth 15 with the epoxy resin composition 16, and then another fiber cloth 15 may be disposed thereon. Repeating those operations may result in multiple fiber cloths 15 stacked in the formed article 1 thereby obtained.

A step for removing mixed air bubbles under reduced or increased pressure is preferably performed during or after the step of filling the epoxy resin composition 16.

The mold 11 is equipped with a heater (not shown) as required. The epoxy resin composition 16 is maintained in a melted state in the step of filling the epoxy resin composition 16. In addition, the epoxy resin composition 16 is maintained in a liquid crystal state when the epoxy resin composition 16 contains an epoxy resin having a mesogenic group in a molecule.

Next, as shown in Fig. 8, the epoxy resin composition 16 in the cavity 12 is applied with a magnetic field having a predetermined magnetic flux density by a pair of permanent magnets 13 as magnetic field generators. The pair of permanent magnets 13 is arranged above and below the mold 11. In this embodiment, lines of magnetic force M of a magnetic field generated by the permanent magnets 13 are arranged matching to the thickness direction of the cavity 12. The magnetic field may be applied to the mold 11 before the cavity 12 is filled with the epoxy resin composition 16. At this time, the lines of magnetic force M coincide with the thickness direction of the epoxy resin composition 16, so the molecular chains of an epoxy resin, or preferably the rigid molecular chains of an epoxy resin having a mesogenic group in a molecule can be oriented in the thickness direction of the epoxy resin composition 16.

While the oriented state of the epoxy resin is maintained, the epoxy resin composition is cured and removed from the mold 11. As a result, the epoxy resin composite formed article 1 of the present invention is obtained.

A prepreg in which each fiber cloth 15 is preliminarily impregnated with the epoxy resin composition 16 may be used. The prepreg may be heated to be in a melted state and applied with a magnetic field so that the molecular chains of the epoxy resin are oriented in the direction intersecting with the fiber cloth as above-described. At this time, the epoxy resin must have melt viscosity to the extent that molecular chains of the resin can be oriented by a magnetic field upon heating.

Furthermore, when fibers are used instead of the fiber cloth 15 in the above production method, the cavity 12 of the mold 11 may be filled with an epoxy resin composition added with the fibers in advance. In this case, when the fibers are longer than the thickness of the cavity 12, the major axis of the each fiber spontaneously orients in the direction along the bottom surface of the cavity 12. Of course, the major axis of the each fiber may be oriented in the direction along the bottom surface of the cavity 12 by an external force such as a flow field or a shear field.

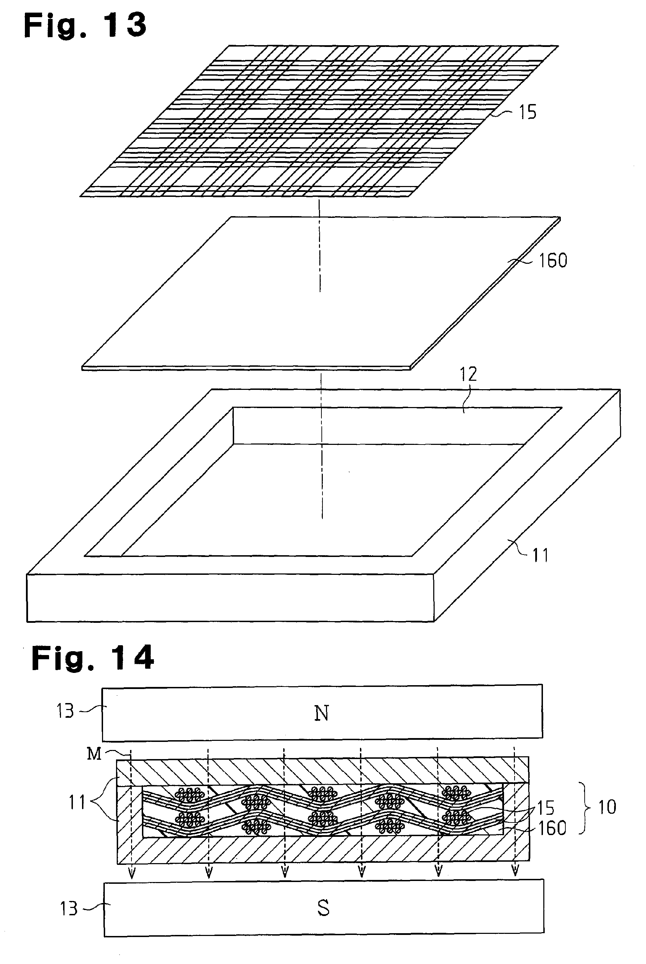

A method for producing the thermoplastic polymer composite formed article 10 formed into a plate-like shape according to the third embodiment, as shown in Fig. 11, will be described. In Fig. 13, the mold 11 is provided with the cavity 12 having a shape corresponding to the desired shape of a formed article, namely a plate shape in this embodiment. At first, as shown in Fig. 13, the thermoplastic polymer composition 160 preformed into a sheet or a flat plate is arranged in the cavity 12 along, or preferably parallel to, the bottom surface of the cavity. Next, at least one fiber cloth 15 is disposed along the upper surface of the sheet of the thermoplastic polymer composition 160, or preferably parallel to the bottom surface of the mold. Those operations are repeated to laminate multiple thermoplastic polymer composition sheets and multiple fiber cloths 15.

The mold 11 is equipped with a heater (not shown) for press molding the laminated thermoplastic polymer composition sheets and fiber cloths 15 under heat. During the press molding, the thermoplastic polymer composition sheets are melted to be in liquid states, and are then impregnated into the fiber cloths 15. In addition, the thermoplastic polymer composition 160 is maintained in a liquid crystal state, when the thermoplastic polymer composition 160 contains a liquid crystal polymer having a mesogenic group in a molecule. During the step of press molding under heat, the cavity 12 is preferably vacuumed to prevent air from mixing into the melted thermoplastic polymer composition 160. Furthermore, as shown in Fig. 14, the pair of permanent magnets 13 is arranged as magnetic field generators above and below the mold 11. These permanent magnets 13 apply a magnetic field having a predetermined magnetic flux density to the polymer composition 160 disposed in the cavity 12. In this embodiment, the lines of magnetic force M of a magnetic field generated by the permanent magnets 13 are directed to coincide with the thickness direction of the cavity 12. As a result, the molecular chains of a thermoplastic polymer, or preferably the rigid molecular chains of a liquid crystal thermoplastic polymer having a mesogenic group in a molecule can be oriented in the thickness direction of the thermoplastic polymer composition 160 molded into a plate-like shape in the cavity 12. The magnetic field may be applied to the mold 11 before the thermoplastic polymer composition sheets are laminated in the cavity 12.

While the oriented state of the thermoplastic polymer is maintained, the thermoplastic polymer composition 160 is solidified, for example, by cooling and removed from the mold 11. As a result, the thermoplastic polymer composite formed article 10 of the present invention is obtained.

A sheet of the thermoplastic polymer composition 160 in which a thermoplastic polymer is mixed with single fibers in advance may be used in the above production method. When the thermoplastic polymer composition 160 containing the single fibers is preliminarily molded into a sheet-like shape, the major axis of each single fiber spontaneously orients in the direction along the surface of the sheet. While this sheet of the thermoplastic polymer composition 160 is heated to be in a melted state, a magnetic field is applied in the thickness direction of the sheet as described above to orient the molecular chains of the thermoplastic polymer in the direction intersecting with the single fibers.

As in the production method of the epoxy resin composite formed article 1 of the first embodiment, the thermoplastic polymer composite formed article 10 can be produced by: disposing a fiber cloth(s) 15 in the cavity 12 of the mold 11 at first; and injecting the thermoplastic polymer composition 160 in a melted state into the cavity 12. In this case, the production method is substantially same as that for the epoxy resin composite formed article 1 of the first embodiment, except that the epoxy resin composition is substituted by a melted thermoplastic polymer composition.

Furthermore, when single fibers are used instead of the fiber cloth 15 in the production method, the thermoplastic polymer composition 160 preliminarily added with single fibers may be injected into the cavity 12 of the mold 11. In this case, when a fiber is longer than the thickness of the cavity 12, the maj or axis of the fiber spontaneously orients in the direction along the bottom surface of the cavity 12. The major axis of the fiber also can be oriented in the direction along the bottom surface of the cavity 12 by an external force such as a flow field or a shear field. Such external force may be generated when the thermoplastic polymer composition is injected into the cavity 12 of the mold 11.

In any case, the thermoplastic polymer composition must have melting viscosity to the extent that its molecular chains can be oriented by a magnetic field in a melted state.

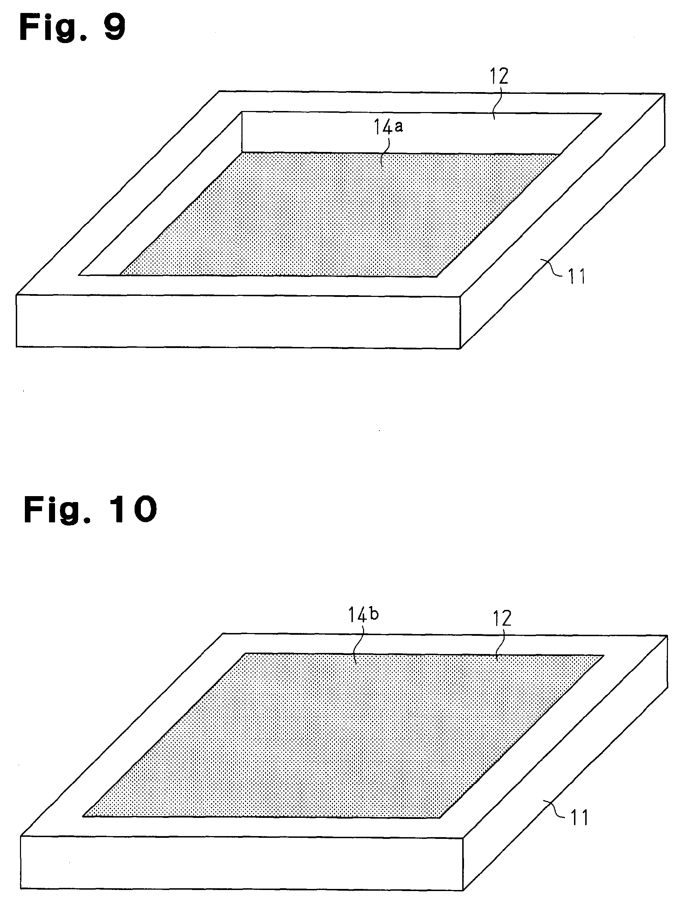

To produce the printed wiring board of the second embodiment shown in Fig. 3, in the production method of the epoxy resin composite formed article 1 of the first embodiment, the conductive layer 14a composed of, for example, metal foil is disposed on the bottom surface of the cavity 12 prior to the step of disposing the fiber cloth 15 in the cavity 12 of the mold 11, as shown in Fig. 9. Furthermore, after the step of filling the cavity 12 with the epoxy resin composition 16, as shown in Fig. 10, the conductive layer 14b is additionally disposed on the epoxy resin composition 16 filled into the cavity 12. After that, a magnetic field is applied to orient the molecular chains of an epoxy resin in the thickness direction of the epoxy resin composition 16 in the same manner as in the production method of the first embodiment shown in Fig. 8. While the oriented state of the epoxy resin is maintained, the epoxy resin composition is cured and removed from the mold 11. As a result, an epoxy resin composite formed article having the conductive layers 14a and 14b disposed on both of its surfaces is obtained. Furthermore, the conductive layers 14a and 14b are patterned by means of a conventionally known method such as etching to produce the printed wiring board 2 of the present invention.

In addition, a multi-layer printed wiring board can be produced by disposing metal foil having a circuit formed therein in advance between the above-mentioned prepregs.

To produce the printed wiring board of the fourth embodiment shown in Fig. 12, as shown in Fig. 9, the conductive layer 14a composed of, for example, metal foil is disposed on the bottom surface of the cavity 12 prior to the step of disposing the thermoplastic polymer composition 160 preliminarily molded into a sheet-like shape and the fiber cloth 15 in the cavity 12 of the mold 11 in the above-mentioned method of producing the thermoplastic polymer composite formed article 10 of the third embodiment. Furthermore, as shown in Fig. 10, the conductive layer 14b is additionally disposed on the thermoplastic polymer composition 160 disposed at the uppermost portion in the cavity 12 after the step of laminating the thermoplastic polymer composition 160 and the fiber cloth 150 in the cavity 12. After that, a magnetic field is applied to orient the molecular chains of a thermoplastic polymer in the thickness direction of the thermoplastic polymer composition 160 in the cavity 12 in the same manner as in the production method of the third embodiment shown in Fig. 8. While the oriented state of the thermoplastic polymer is maintained, the thermoplastic polymer composition is solidified and removed from the mold 11. As a result, a thermoplastic polymer composite formed article having the conductive layers 14a and 14b disposed onbothof its surfaces is obtained. Furthermore, the conductive layers 14a and 14b are patterned by means of a conventionally known method such as etching to produce the printed wiring board 20 of the present invention.

In addition, a multi-layer printed wiring board can be produced by disposing a metal foil(s) having circuits preliminarily formed therein between two polymer composition sheets when the polymer composition sheet and the fiber cloth 15 are disposed in a stack.

The above embodiments can be modified as described below.

An epoxy resin composite formed article or a thermoplastic polymer composite formed article is produced in advance, and a conductive layer composed of metal foil or the like is integrated with the epoxy resin composite formed article or the thermoplastic polymer composite formed article through an adhesive layer or the like to form a printed wiring board.

A metal-plated layer or a conductive paste layer is used as a conductive layer instead of a metal foil. At this time, a prepreg in which a fiber cloth is preliminarily impregnated with an epoxy resin composition or a thermoplastic polymer composition may be used, or an epoxy resin composite formed article or a thermoplastic polymer composite formed article may be produced in advance.

In the epoxy resin composite formed article 1 or the thermoplastic polymer composite formed article 10, each fiber cloth may be arranged to be parallel to the thickness direction of the formed article, and the molecular chains of an epoxy resin or a thermoplastic polymer may be oriented to be parallel to the surface of the formed article. In this case, in the above production method, the pair of permanent magnets 13 is arranged on both sides of the mold 11 to be opposed to each other in such a manner that the lines of magnetic force M are parallel to the surface of the epoxy resin composition 16 or the thermoplastic polymer composition 160 in the cavity 12.

The pair of permanent magnets 13 is arranged to sandwich the mold 11 between them, but one of the permanent magnets 13 may be omitted.

The pair of permanent magnets 13 is arranged in such a manner that the S pole of one of the magnets is opposed to the N pole of the other. However, the pair may be arranged in such a manner that the S poles, or N poles, of both the magnets are opposed to each other.

The lines of magnetic force M are linear, but may be curved or the like. The pair of permanent magnets 13 is arranged in such manners that the lines of magnetic force M extend in one direction. However, the pair of permanent magnets 13 may be arranged in such manners that the lines of magnetic force M extend in two or more directions. Furthermore, one of one line M of magnetic force and the mold 11 may be rotated.

A large number of single fibers may be used instead of a fiber cloth. In this case, in the above production method, multiple single fibers may be arranged in the cavity 12 to be parallel to the surface of a formed article to be obtained before the cavity 12 is filled with the epoxy resin composition 16. Alternatively, the epoxy resin composition 16 or the thermoplastic polymer composition 160 may be mixed with a single fiber in advance. In this case, as described above, it must be noted the fibers are prevented from being oriented in the same direction as the orientation direction of the molecular chains of the epoxy resin or the thermoplastic polymer upon the orientation of these molecular chains by a magnetic field.

The fiber axis of a fiber in a formed article has only to be oriented along a first plane, and is not needed to be exactly parallel to the first plane. In addition, the molecular chains of the epoxy resin or the thermoplastic polymer has only to be oriented in the direction intersecting with the first plane, and is not needed to be exactly perpendicular to the first plane.

Hereinafter, the above embodiments will be described more specifically by way of examples and comparative examples. However, these examples do not limit the scope of the present invention at all.

Examples

Printed wiring board formed of epoxy resin composite formed article

(Example 1)

A printed wiring board using the epoxy resin composite formed article of the present invention as an insulating layer and copper foil as a conductive layer was produced. The epoxy resin composition 16 prepared by mixing terephthalylidene-bis-(4-amino-3-methylphenol)diglycidyl ether, having a mesogenic group in the main chain of a molecule, as an epoxy resin and 4,4'-diamino-1,2-diphenylethane as a curing agent in a ration of 1 mol:0.5 mole was used. A glass cloth "MS130" manufactured by Asahi Fiber-Glass Co., Ltd. (having a weight of 106 g/m$^2$ and a density of 19 fibers/25 mm) was used as the fiber cloth 15. Copper foil (having a thickness of 18 $\mu$m) was used as each of the conductive layers 14a and 14b. The number of glass cloths to be used was set in such a manner that the content of the glass cloth in a formed article would be 8 vol%. Copper foil (the conductive layer 14a) was disposed on the bottom surface of the cavity 12 of the mold 11. Then three glass cloths 15 were disposed over the foil to be parallel to the bottom surface of the cavity 12. After that, the mold 11 was heated to 170°C in temperature, and then the cavity 12 was filled with the epoxy resin composition 16 to impregnate the epoxy resin composition 16 into the glass cloths 15. After that, another copper foil (the conductive layer 14b) was disposed on the epoxy resin composition 16. After that, the composition 16 was cured at 170°C for 10 minutes in a magnetic field having a magnetic flux density of 10 tesla. Thus, a laminate of 2 mm in thickness was obtained. Next, the laminate was drilled to form 200 holes each having a hole diameter of 0.9 mm therein. The resultant was subjected to a copper through-hole plating treatment and then patterned in such a manner land diameter of each hole, a circuit width, and a circuit interval would be 1.3 mm, 0.2 mm, and 0.2 mm, respectively. Thereby, the printed wiring board 2 was obtained.

(Examples 2 and 3)

Each of the printed wiring boards 2 was produced in the same manner as in Example 1 except that the number of glass cloths to be disposed in the cavity 12 (the content of the glass cloth) was changed as shown in Table 1.

(Example 4)

The printed wiring board 2 was produced in the same manner as in Example 1 except that the number of glass cloths to be disposed in the cavity 12 (the content of the glass cloth) and a magnetic flux density were changed as shown in Table 1.

(Example 5)

The same epoxy resin as that of Example 1 and the same curing agent as that of Example 1 were mixed in a ratio of 1 mole:0.5 mole. The mixture was added with glass fibers "CS03BC273" manufactured by Asahi Fiber-Glass Co., Ltd. (each having a fiber length of 3 mm) as single fibers, instead of the glass cloths of Examples 1 to 4, to the epoxy resin composition 16. The amount of glass fibers to be added was set in such a manner that the content of the glass fibers in a formed article would be 21 vol%. The same copper foil as that of Example 1 was used as each of the conductive layers 14a and 14b. At first, copper foil (the conductive layer 14a) was disposed on the bottom surface of the cavity 12 of the mold 11. After that, the mold 11 was heated to 170°C, and then the cavity 12 was filled with the epoxy resin composition 16. Then, another copper foil (the conductive layer 14b) was disposed on the epoxy resin composition 16. After that, the epoxy resin composition 16 was cured at 170°C for 10 minutes in a magnetic field having a magnetic flux density of 10 tesla. Thus, a laminate of 2 mm in thickness was obtained. The directions of the lines of magnetic force M were aligned with the thickness direction of the laminate. Next, the laminate was used to produce the printed wiring board 2 in the same manner as in Example 1.

(Example 6)

An epoxy resin composition obtained by mixing the same epoxy resin as that of Example 1 and of the same curing agent in a ratio of 1 mole:0.5 mole as that of Example 1 was used. The same glass cloth as that of Example 1 was used as a fiber cloth. The same copper foil as that of Example 1 was used as each of the conductive layers 14a and 14b. The number of glass cloths to be used was set in such a manner that the content of the glass cloth in a formed article would be 17 vol%. At first, one glass cloth 15 was impregnated with the epoxy resin composition 16 melted by heating. After that, the resultant was solidified by cooling in a magnetic field having a magnetic flux density of 10 tesla to produce a prepreg. Copper foil was disposed in the cavity 12 of the same mold 11 as that of Example 1, and ten prepregs thus obtained were disposed in a stack over the copper foil. Furthermore, another copper foil was disposed on the resultant. The resultant was heated and pressurized at 170°C in a magnetic field having a magnetic flux density of 10 tesla to produce a laminate of 2 mm in thickness. The directions of the lines of magnetic force M were aligned with the thickness direction of the laminate. Next, the laminate was used to produce the printed wiring board 2 in the same manner as in Example 1.

(Comparative Example 1)

The epoxy resin composition 16 was used to produce a printed wiring board containing neither fiber cloth nor single fibers. The epoxy resin composition 16 was prepared by mixing of terephthalylidene-bis-(4-amino-3-methylphenol) diglycidyl ether having a mesogenic group in a molecule as an epoxy resin and of 4,4'-diamino-1,2-diphenylethane as a curing agent in a ratio of 1 mole:0.5 mole. The same copper foil as that of Example 1 was used as a conductive layer. At first, copper foil (the conductive layer 14a) was disposed on the bottom surface of the cavity 12 of the mold 11. After that, the mold 11 was heated to 170°C, and then the cavity 12 was filled with the epoxy resin composition 16. After that, another copper foil (the conductive layer 14b) was disposed on the epoxy resin composition 16. Then, the epoxy resin composition 16 was cured at 170°C for 10 minutes with no magnetic field applied to produce a laminate of 2 mm in thickness. Next, the laminate was used to produce the printed wiring board 2 in the same manner as in Example 1.

(Comparative Example 2)

An epoxy resin composition prepared by mixing terephthalylidene-bis-(4-amino-3-methylphenol)diglycidyl ether having a mesogenic group in a molecule as an epoxy resin and 4,4'-diamino-1,2-diphenylethane as a curing agent in a ratio of 1 mole:0.5 mole was used to produce a printed wiring board containing neither fiber cloth nor fiber. The same copper foil as that of Example 1 was used as a conductive layer. Copper foil (the conductive layer 14a) was disposed on the bottom surface of the cavity 12 of the mold 11. After that, the mold 11 was heated to 170°C, and then the cavity 12 was filled with the epoxy resin composition. After that, another copper foil (the conductive layer 14b) was disposed on the epoxy resin composition 16. Next, the resultant was cured at 170°C for 10 minutes in a magnetic field having a magnetic flux density of 10 tesla to produce a printed wiring board having a thickness of 2 mm. The directions of the lines of magnetic force M were aligned with the thickness direction of the laminate. Next, the laminate was used to produce the printed wiring board 2 in the same manner as in Example 1.

(Comparative Example 3)

The same epoxy resin composition 16, glass cloth, and copper foil as those of Example 1 were used. The number of glass cloths was set in such a manner that the content of the glass cloth in a formed article would be 17 vol%. At first, copper foil (the conductive layer 14a) was disposed on the bottom surface of the cavity 12 of the mold 11, and ten glass cloths were disposed in a stack over the foil to be parallel to the bottom surface of the cavity 12. After that, the mold 11 was heated to 170°C, and then the cavity 12 was filled with the epoxy resin composition 16 to impregnate the epoxy resin composition 16 into the glass cloths 15. After that, another copper foil (the conductive layer 14b) was disposed on the epoxy resin composition 16. After that, the epoxy resin composition 16 was cured at 170°C for 10 minutes with no magnetic field applied. Thus, a laminate of 2 mm in thickness was obtained. Next, the laminate was used to produce the printed wiring board 2 in the same manner as in Example 1.

As for a portion of the epoxy resin composite formed article in each of the printed wiring boards produced in Examples 1 to 6 and Comparative Example 2, the degree of orientation α of the epoxy resin of was measured. A test piece (2 mm in thickness) was used to determine the degree of orientation α of the epoxy resin from an X-ray diffraction pattern measured by means of an X-ray diffraction instrument ("M18XHF[22]-SRA" manufactured by MAC Science Co., Ltd). Each test piece is composed only of the epoxy resin composite formed article portion of each of the printed wiring boards of Examples 1 to 6 and Comparative Example 2.

In addition, the thermal expansion coefficients of the epoxy resin composite formed article portion of each of the printed wiring boards 2 produced in the respective examples and comparative examples in the direction along the surface of the printed wiring board 2 and in the thickness direction of the printed wiring board 2 were measured. A test piece (2 mm) was used to measure a thermal expansion coefficient by means of an apparatus for thermomechanical analysis ("TMA-50" manufactured by Shimadzu Corporation) at a load of 3 g and a rate of temperature increase of 10°C/min. Each test piece is composed only of the epoxy resin composite formed article portion of each of the printed wiring boards of the respective examples and comparative examples.

Furthermore, a through-hole reliability test was conducted on each of the printed wiring boards 2. Each of the printed wiring boards 2 was immersed in oil at 260°C for 10 seconds and in water at 20°C for 10 seconds in conformance with JIS-C0025. This operation was defined as one cycle. The cycle was repeated, and the number of cycles at which any breakage of wirings occurred was counted.

Table 1 shows the measured values and test results of the printed wiring boards produced in Examples 1 to 6 and Comparative Examples 1 to 3.

Table 1

|  | Example | | | | | | Comparative Example | | |
|---|---|---|---|---|---|---|---|---|---|
|  | 1 | 2 | 3 | 4 | 5 | 6 | 1 | 2 | 3 |
| Content of glass cloth (vol%) (Number of glass cloths) | 8 (3) | 14 (5) | 17 (10) | 17 (10) | - | 17 (10) | - | - | 17 (10) |
| Content of glass fibers (vol%) | - | - | - | - | 21 |  | - | - | - |
| Magnetic flux density (tesla) | 10 | 10 | 10 | 5 | 10 | 10 | 0 | 10 | 0 |
| Degree of orientation a | 0.72 | 0.72 | 0.72 | 0.70 | 0.72 | 0.70 | - | 0.72 | - |
| Thermal expansion coefficient in thickness direction ($10^{-6}$/K) | 18 | 20 | 23 | 21 | 10 | 25 | 66 | 3.5 | 93 |
| Thermal expansion coefficient in direction along surface ($10^{-6}$/K) | 40 | 21 | 15 | 16 | 40 | 14 | 69 | 105 | 17 |
| Through-hole reliability (Number of cycles) | 160 | 250 | 270 | 265 | 230 | 255 | 50 | 70 | 20 |

As is apparent from the results shown in Table 1, in each of Examples 1 to 4 and 6, each of the thermal expansion coefficients in the direction along the surface of the wiring board in which the glass cloth extends and in the thickness direction in which the molecular chains of the epoxy resin were oriented exhibited a lower value, namely, 40 $\times$ 10$^{-6}$ /K or less. In Example 5 as well, the thermal expansion coefficient in the direction along the surface of the wiring board as well as that in the thickness direction in which the molecular chains of the epoxy resin was oriented exhibited a lower value (40 $\times$ 10$^{-6}$ /K or less). The reason for this is probably as follows. The each fiber axis of the glass fibers added to the epoxy resin composition 16 were oriented in the direction along the surface of the wiring board because the composition was molded into a plate-like shape. Even when a magnetic field was applied thereafter, the fibers were hardly influenced by the magnetic field because of its relative long fiber length (3 mm), and hence the oriented state was maintained. Accordingly, in each of Examples 1 to 6, the difference between the thermal expansion coefficient in the direction along the surface and the thermal expansion coefficient in the thickness direction is at most 30 $\times$ 10$^{-6}$ /K (in Example 3). This shows that a printed wiring board composed of an epoxy resin composite in which thermal expansion coefficients are controlled to be small in both the direction along the surface of the wiring board and the thickness direction were obtained in each of these Examples. In addition, each of the printed wiring boards of Examples 1 to 6 had better through-hole reliability than that of each of the printed wiring boards of Comparative Examples 1 to 3.

On the other hand, in Comparative Example 1, the difference between the thermal expansion coefficients in the direction along the surface of the wiring board and in the thickness direction was small, but each of the thermal expansion coefficients exceeded 60 $\times$ 10$^{-6}$ /K. In Comparative Example 2, the thermal expansion coefficient in the thickness direction, in which the molecular chains of the epoxy resin were oriented, showed a lower value, but the thermal expansion coefficient in the direction along the surface showed an extremely higher value. In Comparative Example 3, the thermal expansion coefficient in the direction along the surface in which a glass cloth expanded showed a lower value, but the thermal expansion coefficient in the thickness direction showed a higher value. In addition, none of the printed wiring boards of Comparative Examples 1 to 3 provided sufficient through-hole reliability.

Printed wiring board formed of thermoplastic polymer composite formed article

(Example 7)

A printed wiring board using the thermoplastic polymer composite formed article 10 of the present invention as an insulating layer and copper foil as a conductive layer was produced. The thermoplastic polymer composition 160 containing a thermoplastic polymer including 4-hydroxy benzoate/(terephthalic acid and ethylene glycol (molar ratio 1 : 1)) = 80/20 mol% as a repeating unit was used. A "1080" manufactured by Asahi-Schwebel Co., Ltd. serving as a glass cloth (having a weight of 48 g/m$^2$ and a density of 60 (vertical) $\times$ 47 (horizontal) fibers/inch) was used as the fiber cloth 15. Electrolytic copper foil manufactured by NIKKO MATERIALS Co., Ltd. (having a thickness of 18 $\mu$m) was used as each of the conductive layers 14a and 14b. The number of glass cloths to be used was set in such a manner that the content of the glass cloth in a formed article would be 3.7 vol%.

At first, copper foil (the conductive layer 14a) was disposed on the bottom surface of the cavity 12 of the mold 11. Then the thermoplastic polymer composition 160 preliminarily molded into a sheet having a thickness of 0.40 mm and the glass cloth 15 were disposed in a stack over the foil to be parallel to the bottom surface of the cavity 12. Four tiers each composed of the thermoplastic polymer composition 160 and the glass cloth 150 were superimposed, and then a sheet of the thermoplastic polymer composition 160 was disposed thereover. Then, another copper foil (the conductive layer 14b) was disposed on the resultant. After that, the mold was heated and pressurized at 310°C for 15 minutes in a magnetic field having a magnetic flux density of 10 tesla, and was then slowly cooled to room temperature to produce a laminate of 2 mm in thickness. The directions of the lines of magnetic force M were aligned with the thickness direction of the laminate. Next, the laminate was drilled to form 200 holes each having a hole diameter of 0.9 mm therein, and was subjected to a copper through-hole plating treatment. After that, the resultant was patterned in such a manner that the land diameter of each hole, the circuit width, and the circuit interval would be 1.3 mm, 0.2 mm, and 0.2 mm, respectively, to thereby produce the printed wiring board 20.

(Example 8)

The printed wiring board 20 was produced in the same manner as in Example 7 except that the number of glass cloths to be disposed in the cavity 12 (the content of the glass cloth) was changed as shown in Table 2.

(Example 9)

The printed wiring board 20 was produced in the same manner as in Example 7 except that the number of glass cloths to be disposed in the cavity 12 (the content of the glass cloth) and a magnetic flux density were changed as shown in Table 2.

(Example 10)

The printed wiring board 20 was produced in the same manner as in Example 7 except that: the thermoplastic polymer composition 160 synthesized by reacting 2,2'-bipyridine-4,4'-dicarboxylic acid with 1,12-diaminododecane was used as a thermoplastic polymer; and the number of glass cloths to be disposed in the cavity 12 (the content of the glass cloth) was changed as shown in Table 2.

(Example 11)

The same thermoplastic polymer as that of Example 7 was mixed with glass fibers "CS03BC273" manufactured by Asahi Fiber-Glass Co., Ltd. (1 mm in fiber length) as single fibers instead of the glass cloths of Examples 7 to 10 to prepare the thermoplastic polymer composition 160. The amount of glass fibers to be added was set in such a manner that the content of the glass fibers in the thermoplastic polymer composition 160 would be 19 vol%. At first, the thermoplastic polymer composition 160 was injected into the mold 11 placed in a magnetic field having a magnetic flux density of 10 tesla. The resultant was heated and pressurized at 310°C for 15 minutes, and was then slowly cooled to room temperature. Thereby, the thermoplastic polymer composite formed article 10 having a thickness of 2 mm was obtained. The directions of the lines of magnetic force M were aligned with the thickness direction of the formed article. Next, both surfaces of the thermoplastic polymer composite formed article 10 were plated with copper to form the conductive layers 14a and 14b. The thermoplastic polymer composite formed article 10 having the conductive layers 14a and 14b was patterned in the same manner as in Example 1 to produce the printed wiring board 20.

(Comparative Example 4)

A thermoplastic polymer composition 160 identical to that of each of Examples 7 to 9 was used to produce a printed wiring board containing neither fiber cloth nor fiber. The same copper foil as that of Example 7 was used as a conductive layer. At first, copper foil (the conductive layer 14a) was disposed on the bottom surface of the cavity 12 of the mold 11. After that, the thermoplastic polymer composition 160 preliminarily molded into a sheet of 2 mm in thickness was disposed on the foil to be parallel to the bottom surface of the cavity 12. Then, another copper foil (the conductive layer 14b) was disposed on the composition. The mold was heated and pressurized at 310°C for 15 minutes with no magnetic field applied, and was then slowly cooled to room temperature to produce a laminate of 2 mm in thickness. Next, the laminate was used to produce a printed wiring board in the same manner as in Example 1.

(Comparative Example 5)

The thermoplastic polymer composition 160 identical to that of each of Examples 7 to 9 was used to produce a printed wiring board containing neither fiber cloth nor fiber. The same copper foil as that of Example 7 was used as a conductive layer. At first, copper foil (the conductive layer 14a) was disposed on the bottom surface of the cavity 12 of the mold 11. After that, the thermoplastic polymer composition 160 preliminarily molded into a sheet of 2 mm in thickness was arranged on the foil to be parallel to the bottom surface of the cavity 12. Then, another copper foil (the conductive layer 14b) was disposed on the composition. After that, the mold was heated and pressurized at 310°C for 15 minutes in a magnetic field having a magnetic flux density of 10 tesla, and was then slowly cooled to room temperature to produce a laminate of 2 mm in thickness. The directions of the lines of magnetic force M were aligned with the thickness direction of the laminate. Next, the laminate was used to produce a printed wiring board in the same manner as in Example 7.

(Comparative Example 6)

A printed wiring board was produced in the same manner as in Example 9 using a thermoplastic polymer composition and a glass cloth composed of the same materials in the same amounts as those of Example 9 except that no magnetic field was applied upon molding.

As for the thermoplastic polymer composite formed article portion of each of the printed wiring boards produced in Examples 7 to 11 and Comparative Examples 4 to 6, the degree of orientation $\alpha$ of the thermoplastic polymer, and thermal expansion coefficients in the direction along the surface of the printed wiring board and in the thickness direction of the printed wiring board were measured in the same manners as those described above with respect to Examples 1 to 6 and Comparative Example 2. The degree of orientation $\alpha$ in each of Comparative Examples 4 and 6 could not be calculated because no peak was observed in the X-ray diffraction intensity distribution of a test piece of the each of these Comparative Examples.

Furthermore, a through-hole reliability test was conducted on each of the printed wiring boards. Each of the printed wiring boards 2 was immersed in silicone oil at 260°C for 5 seconds and in 2-propanol at 20°C for 20 seconds in conformance with JIS-C5012. This operation was defined as one cycle. The cycle was repeated, and the number of cycles at which cracking, peeling, or breaking of wiring occurred was counted.

Table 2 shows the measured values and test results of the printed wiring boards produced in Examples 7 to 11 and Comparative Examples 4 to 6.

Table 2

| | Example | | | | | Comparative Example | | |
|---|---|---|---|---|---|---|---|---|
| | 7 | 8 | 9 | 10 | 11 | 4 | 5 | 6 |
| Content of glass cloth (vol%) (Number of glass cloths) | 3.7 (4) | 6.5 (7) | 6.5 (7) | 5.6 (6) | - | - | - | 6.5 (7) |
| Content of glass fibers (vol%) | - | - | - | - | 19 | - | - | - |
| Magnetic flux density (tesla) | 10 | 10 | 5 | 10 | 10 | 0 | 10 | 0 |
| Degree of orientation $\alpha$ | 0.82 | 0.82 | 0.78 | 0.81 | 0.83 | - | 0.90 | - |
| Thermal expansion coefficient in thickness direction ($10^{-6}$/K) | 6 | 10 | 22 | 25 | 28 | 181 | -1 | 127 |
| Thermal expansion coefficient in direction along surface ($10^{-6}$/K) | 35 | 20 | 13 | 29 | 27 | 44 | 178 | 13 |
| Through-hole reliability (Number of cycles) | 196 | 263 | 254 | 260 | 258 | 59 | 23 | 33 |

As is apparent from the results shown in Table 2, in each of Examples 7 to 10, each of the thermal expansion coefficients in the direction along the surface of the wiring board in which a glass cloth extended and in the thickness direction in which the molecular chains of the thermoplastic polymer were oriented exhibited a lower value ($35 \times 10^{-6}$ /K or less). In Example 5, in which a glass single fiber was used, as well, the thermal expansion coefficient in the direction along the surface of the wiring board as well as that in the thickness direction in which the molecular chains of the thermoplastic polymer was oriented exhibited a lower value ($28 \times 10^{-6}$ /K or less). The reason for this is probably as follows. Each major axis of the glass fibers in the thermoplastic polymer composition 160 were oriented in the direction along the bottom surface of the cavity 12 of the mold 11, that is, the direction along the surface of the laminate owing to a flow of the composition 160 caused by injecting the composition 160 into the cavity 12. Even when a magnetic field was applied in the thickness direction of the laminate thereafter, the glass fiber was hardly influenced by the magnetic field because of its small anisotropic diamagnetic susceptibility $\chi_a$, and hence the oriented state was maintained.

Accordingly, in a printed wiring board obtained in each of Examples 7 to 11, the difference between the thermal expansion coefficients in the direction along the surface and in the thickness direction is at most $29 \times 10^{-6}$ /K (Example 1). This shows that a printed wiring board composed of a thermoplastic polymer composite formed article in which thermal expansion coefficients are controlled to be small in both the direction along the surface of the wiring board and in the thickness direction was obtained in these embodiments. In addition, each of the printed wiring boards of Examples 7 to 11 had better through-hole reliability than that of each of the printed wiring boards of Comparative Examples 4 to 6.

On the other hand, in Comparative Example 4, the thermal expansion coefficient in the direction along the surface showed a relatively lower value, but the thermal expansion coefficient in the thickness direction showed a higher value. In Comparative Example 5, the thermal expansion coefficient in the thickness direction in which the molecular chains of the thermoplastic polymer were oriented showed an extremely lower value, but the thermal expansion coefficient in the direction along the surface showed a higher value. In Comparative Example 6, the thermal expansion coefficient in the direction along the surface in which a glass cloth expanded showed a lower value, but the thermal expansion coefficient in the thickness direction showed a higher value. In addition, none of the printed wiring boards of Comparative Examples 4 to 6 provided sufficient through-hole reliability.

**Claims**

1. An epoxy resin composite formed article composed of an epoxy resin and fibers, **characterized in that**:

   the fibers are arranged along a first plane and molecular chains of the epoxy resin are oriented in a direction intersecting with the first plane therein,
   and that a degree of orientation $\alpha$ of the molecular chains of the epoxy resin is in a range of 0.5 or more and less than 1, as determined by the following expression (1) based on X-ray diffraction measurement,

$$\text{Degree of orientation } \alpha = (180-\Delta\beta/180) \quad (1)$$

wherein $\Delta\beta$ represents a full width at half maximum in an intensity distribution measured in an azimuth angle direction from 0 to 360° at a fixed peak scatter angle in the X-ray diffraction measurement,
and that each of the thermal expansion coefficients of the epoxy resin composite formed article in the direction along the first plane and in the direction intersecting with the first plane is in a range of $5 \times 10^{-6}$ to $50 \times 10^{-6}$ (/K) and a difference between the thermal expansion coefficients in the direction along the first plane and in the direction intersecting with the first plane is $30 \times 10^{-6}$ (/K) or less.

2. The epoxy resin composite formed article according to claim 1, **characterized in that**:

   the epoxy resin is a liquid crystalline epoxy resin having a mesogenic group in its molecular.

3. The epoxy resin composite formed article according to claims 1 or 2, **characterized in that**:

   the fibers comprise at least one of a fiber cloth and single fibers.

4. The epoxy resin composite formed article according to any one of claims 1 to 3, **characterized in that**:

   the fibers consist of at least one selected from glass fibers, ceramic fibers, carbon fibers, metal fibers, and organic fibers.

5. A printed wiring board formed of the epoxy resin composite formed article according to any one of claims 1 to 4, **characterized in that**:

   an electrically conductive layer is provided on at least one of a surface and inside of the epoxy resin composite formed article.

6. A method for producing the epoxy resin composite formed article according to any one of claims 1 to 4, **characterized by** the steps of:

   disposing the fibers within a cavity of a mold in such a manner that the fibers are arranged along the first plane,
   impregnating the fibers with an epoxy resin composition by filling the cavity of the mold with the epoxy resin composition,
   orienting molecular chains of the epoxy resin in a direction intersecting with the first plane, and
   curing the epoxy resin composition while the orientation of the molecular chains of the epoxy resin is maintained.

7. The method according to claim 6, **characterized in that**:

   in the step of orienting the molecular chains of the epoxy resin, the orientation of the molecular chains of the epoxy resin is accomplished by application of a magnetic field thereto.

8. A method for producing the printed wiring board according to claim 5, **characterized by** the steps of:

   disposing the fibers within a cavity of a mold in such a manner that the fibers are arranged along the first plane,
   impregnating the fibers with an epoxy resin composition by filling the cavity of the mold with the epoxy resin composition,
   orienting molecular chains of the epoxy resin in a direction intersecting with the first plane,
   curing the epoxy resin composition while the orientation of the molecular chains of the epoxy resin is maintained, and
   providing an electrically conductive layer on at least one of a surface and inside of the printed wiring board at least either prior to the step of disposing, or after the steps of impregnating, or curing.

9. The method according to claim 8, **characterized in that**:

in the step of orienting, the orientation of the molecular chains of the epoxy resin is accomplished by application of a magnetic field thereto.

10. A method for producing the epoxy resin composite formed article according to any one of claims 1 to 4, **characterized by** the steps of:

preparing an epoxy resin composition containing the fibers,
filing a cavity of a mold with the epoxy resin composition in such a manner that a major axis of each of the fibers are arranged along the first plane,
orienting molecular chains of the epoxy resin in a direction intersecting with the first plane, and
curing the epoxy resin composition, while the orientation of the molecular chains of the epoxy resin is maintained.

11. A thermoplastic polymer composite formed article composed of a thermoplastic polymer and fibers, **characterized in that**:

the fibers are arranged along a first plane and molecular chains of the thermoplastic polymer are oriented in a direction intersecting with the first plane therein,
and that a degree of orientation $\alpha$ of the molecular chains of the thermoplastic polymer is in a range of 0.5 or more and less than 1, as determined by the following expression (1) based on X-ray diffraction measurement,

$$\text{Degree of orientation } \alpha = (180-\Delta\beta/180) \quad (1)$$

wherein $\Delta\beta$ represents a full width at half maximum in an intensity distribution measured in an azimuth angle direction from 0 to 360° with a fixed peak scatter angle in the X-ray diffraction measurement,
and that each of the thermal expansion coefficients of the thermoplastic polymer composite formed article in the direction along to the first plane and in the direction intersecting with the first plane is in a range of $5 \times 10^{-6}$ to $50 \times 10^{-6}$ (/K) and a difference between the thermal expansion coefficients in the direction along the first plane and in the direction intersecting with the first plane is $30 \times 10^{-6}$ (/K) or less.

12. The thermoplastic polymer composite formed article according to claim 11, **characterized in that**:

the thermoplastic polymer is a liquid crystalline polymer having a mesogenic group in its molecular.

13. The thermoplastic polymer composite formed article according to claims 12, **characterized in that**:

the liquid crystalline polymer is at least one selected from aromatic polyester, aromatic polyamide, and aromatic polyesteramide.

14. The thermoplastic polymer composite formed article according to any one of claims 11 to 13, **characterized in that**:

the fibers comprise at least one of a fiber cloth and single fibers.

15. The thermoplastic polymer composite formed article according to any one of claims 11 to 15, **characterized in that**:

the fibers consist of at least one selected from glass fibers, ceramic fibers, carbon fibers, metal fibers, and organic fibers.

16. A printed wiring board formed of the thermoplastic polymer composite formed article according to any one of claims 11 to 15, **characterized in that**:

an electrically conductive layer is provided on at least one of a surface and inside of the thermoplastic polymer composite formed article.

17. A method for producing the thermoplastic polymer composite formed article according to any one of claims 11 to 15, **characterized by** the steps of:

disposing the fibers within a cavity of a mold in such a manner that the fibers are arranged along the first plane, impregnating the fibers with a thermoplastic polymer composition by filling the cavity of the mold with the thermoplastic polymer composition,

orienting molecular chains of the thermoplastic polymer in a direction intersecting with the first plane, and solidifying the thermoplastic polymer composition while the orientation of the molecular chains of the thermoplastic polymer is maintained.

18. A method for producing the thermoplastic polymer composite formed article according to any one of claims 11 to 15, **characterized by** the steps of:

forming a preform of a thermoplastic polymer composition containing the thermoplastic polymer,

disposing the preform and the fibers within a cavity of a mold in such a manner the preform and the fibers are arranged along the first plane,

impregnating the fibers with a thermoplastic polymer composition by melting the preform,

orienting molecular chains of the thermoplastic polymer in a direction intersecting with the first plane, and solidifying the thermoplastic polymer composition while the orientation of the molecular chains of the thermoplastic polymer is maintained.

19. A method for producing the thermoplastic polymer composite formed article according to any one of claims 11 to 15, **characterized by** the steps of:

preparing a thermoplastic polymer composition containing the thermoplastic polymer and the fibers,

filing a cavity of a mold with the thermoplastic polymer composition in such a manner that a major axis of each of the fibers are arranged along the first plane,

orienting molecular chains of the thermoplastic polymer in a direction intersecting with the first plane, and solidifying the thermoplastic polymer composition, while the orientation of the molecular chains of the thermoplastic polymer is maintained.

20. The method according to any one of claims 17 to 19, **characterized in that**:

in the step of orienting the molecular chains of the thermoplastic polymer in the direction intersecting with the first plane, the orientation of the molecular chains of the thermoplastic polymer is accomplished by application of a magnetic field thereto.

21. A method for producing the printed wiring board according to claim 16, **characterized by** the steps of:

disposing the fibers within a cavity of a mold in such a manner that the fibers are arranged along the first plane, impregnating the fibers with a thermoplastic polymer composition by filling the cavity of the mold with the thermoplastic polymer composition,

orienting molecular chains of the thermoplastic polymer in a direction intersecting with the first plane, solidifying the thermoplastic polymer composition while the orientation of the molecular chains of the thermoplastic polymer is maintained, and

providing an electrically conductive layer on at least one of a surface and inside of the printed wiring board at least either prior to the step of disposing, or after the steps of impregnating, or solidifying.

22. A method for producing the printed wiring board according to claim 16, **characterized by** the steps of:

forming a preform of a thermoplastic polymer composition containing the thermoplastic polymer,

disposing the preform and the fibers within a cavity of a mold in such a manner the preform and the fibers are arranged along the first plane,

impregnating the fibers with an thermoplastic polymer composition by melting the preform,

orienting molecular chains of the thermoplastic polymer in a direction intersecting with the first plane,

solidifying the thermoplastic polymer composition while the orientation of the molecular chains of the thermoplastic polymer is maintained, and

providing an electrically conductive layer on at least one of a surface and inside of the printed wiring board at least either prior to the step of disposing, or after the steps of impregnating, or solidifying.

**23.** A method for producing the printed wiring board according to claim 16, **characterized by** the steps of:

preparing a thermoplastic polymer composition containing the thermoplastic polymer and the fibers,
filing a cavity of a mold with the thermoplastic polymer composition in such a manner that a major axis of each of the fibers are arranged along the first plane,
orienting molecular chains of the thermoplastic polymer in a direction intersecting with the first plane, and
solidifying the thermoplastic polymer composition, while the orientation of the molecular chains of the thermoplastic polymer is maintained, and
providing an electrically conductive layer on at least one of a surface and inside of the printed wiring board at least either prior to the step of disposing, or after the steps of impregnating, or solidifying.

**24.** The method according to any one of claims 21 to 23, **characterized in that**:

in the step of orienting the molecular chains of the thermoplastic polymer in the direction intersecting with the first plane, the orientation of the molecular chains of the thermoplastic polymer is accomplished by application of a magnetic field thereto.

**25.** A polymer composite formed article composed of a polymer and fibers, **characterized in that**:

the fibers are arranged along a first plane and molecular chains of the polymer are oriented in a direction intersecting with the first plane therein,
and that a degree of orientation $\alpha$ of the molecular chains of the polymer is in a range of 0.5 or more and less than 1, as determined by the following expression (1) based on X-ray diffraction measurement,

$$\text{Degree of orientation } \alpha = (180-\Delta\beta/180) \quad (1)$$

wherein $\Delta\beta$ represents a full width at half maximum in an intensity distribution measured in an azimuth angle direction from 0 to 360° with a fixed peak scatter angle in the X-ray diffraction measurement,
and that each of the thermal expansion coefficients of the polymer composite formed article in the direction along the first plane and in the direction intersecting with the first plane is in a range of $5 \times 10^{-6}$ to $50 \times 10^{-6}$ (/K) and a difference between the thermal expansion coefficients in the direction along the first plane and in the direction intersecting with the first plane is $30 \times 10^{-6}$ (/K) or less.

## Fig. 1

## Fig. 2

## Fig. 3

# Fig. 4

# Fig. 5

## Fig. 6

## Fig. 7

## Fig. 8

# Fig. 9

# Fig. 10

# Fig. 11

# Fig. 12

## Fig. 13

## Fig. 14

## INTERNATIONAL SEARCH REPORT

International application No.

PCT/JP2005/002643

| A. CLASSIFICATION OF SUBJECT MATTER |
|---|
| Int.Cl⁷ C08J5/24, B32B15/08, C08K7/02, C08L63/00, H05K1/03, H05K3/00//C08L101:00 |

According to International Patent Classification (IPC) or to both national classification and IPC

| B. FIELDS SEARCHED |
|---|

Minimum documentation searched (classification system followed by classification symbols)
Int.Cl⁷ C08J5/24, B32B15/08, C08K7/02, C08L63/00, H05K1/03, H05K3/00//C08L101:00

Documentation searched other than minimum documentation to the extent that such documents are included in the fields searched
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| A | WO 2002/094905 A1 (Hitachi, Ltd.), 28 November, 2002 (28.11.02), Claims & US 2004/0147709 A1 & JP 2002-592375 A | 1-25 |
| A | JP 2004-050704 A (Porima Tekku Kabushiki Kaisha), 19 February, 2004 (19.02.04), Claims; page 7, Par. No. [0034]; page 8, Par. No. [0044] (Family: none) | 1-25 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search 11 April, 2005 (11.04.05) | Date of mailing of the international search report 26 April, 2005 (26.04.05) |
|---|---|
| Name and mailing address of the ISA/ Japanese Patent Office | Authorized officer |
| Facsimile No. | Telephone No. |

Form PCT/ISA/210 (second sheet) (January 2004)

**INTERNATIONAL SEARCH REPORT**

International application No.

PCT/JP2005/002643

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2004-051852 A  (Porima Tekku Kabushiki Kaisha), <br> 19 February, 2004 (19.02.04), <br> Claims; page 7, Par. No. [0033]; page 9, <br> Par. No. [0049]; page 10, Par. No. [0055] <br> & EP 1384567 A1          & US 2004/0152829 A1 | 1-25 |
| P,A | JP 2004-149722 A  (Porima Tekku Kabushiki Kaisha), <br> 27 May, 2004 (27.05.04), <br> Claims <br> & EP 1416031 A1          & US 2004/0087697 A1 <br> & KR 2004038673 A | 1-25 |
| P,A | JP 2004-225034 A  (Porima Tekku Kabushiki Kaisha), <br> 12 August, 2004 (12.08.04), <br> Claims; page 8, Par. No. [0038]; page 9, <br> Par. No. [0043]; page 10, Par. No. [0048] <br> (Family: none) | 1-25 |
| P,A | JP 2004-276478 A  (Porima Tekku Kabushiki Kaisha), <br> 07 October, 2004 (07.10.04), <br> Claims <br> (Family: none) | 1-25 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002053646 A
- JP 2001288251 A
- JP 10145020 A
- JP 11147960 A
- JP 8255959 A
- JP 10034742 A
- JP 2004175995 A